(19) Europäisches Patentamt
European Patent Office
Office européen des brevets

(11) EP 4 559 971 A1

(12) **EUROPEAN PATENT APPLICATION**
published in accordance with Art. 153(4) EPC

(43) Date of publication:
**28.05.2025 Bulletin 2025/22**

(21) Application number: **23842702.5**

(22) Date of filing: **07.06.2023**

(51) International Patent Classification (IPC):
***C08L 33/00*** (2006.01) ***C08F 2/44*** (2006.01)
***C08F 220/02*** (2006.01) ***C08F 293/00*** (2006.01)
***C08K 3/10*** (2018.01) ***C09K 11/02*** (2006.01)
***C09K 11/70*** (2006.01) ***C09K 11/88*** (2006.01)

(52) Cooperative Patent Classification (CPC):
**C08F 2/44; C08F 220/02; C08F 220/04; C08F 220/10; C08F 265/00; C08F 293/00; C08K 3/013; C08K 3/10; C08L 33/00; C09K 11/02; C09K 11/70; C09K 11/88**

(86) International application number:
**PCT/JP2023/021091**

(87) International publication number:
**WO 2024/018770 (25.01.2024 Gazette 2024/04)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **21.07.2022 JP 2022116246**

(71) Applicants:
- **Sumitomo Chemical Company, Limited**
  **Tokyo 103-6020 (JP)**
- **Otsuka Chemical Co., Ltd.**
  **Osaka-shi, Osaka 540-0021 (JP)**

(72) Inventors:
- **TSUCHIYA, Mitsuo**
  **Osaka-shi, Osaka 554-8558 (JP)**
- **HARADA, Yoshihiro**
  **Osaka-shi, Osaka 554-8558 (JP)**
- **KOMATSU, Yoshifumi**
  **Niihama-shi, Ehime 7920015 (JP)**
- **ODA, Yutaro**
  **Tokushima-shi, Tokushima 771-0193 (JP)**

(74) Representative: **Vossius & Partner Patentanwälte Rechtsanwälte mbB**
**Siebertstrasse 3**
**81675 München (DE)**

# (54) COMPOSITION, FILM, AND DISPLAY DEVICE

(57) Provided is a composition containing a quantum dot (A) and a vinyl copolymer (B), wherein the vinyl copolymer (B) has a structural unit derived from (meth) acrylic acid, a structural unit derived from (meth)acrylate having a carboxy group, and a structural unit derived from (meth)acrylate having no carboxy group; contains a tellurium compound; has a molecular weight distribution of 2.0 or less; and has an acid value of 100 mgKOH/g to 150 mgKOH/g.

EP 4 559 971 A1

## Description

TECHNICAL FIELD

The present invention relates to a composition and a film formed therefrom, and a display device including the film.

BACKGROUND ART

As a curable resin composition for forming a cured film, such as a wavelength conversion film included in a display device, there is known those including quantum dots (PTL1).

CITATION LIST

PATENT LITERATURE

PTL1: Japanese Patent Laying-Open No. 2016-71362

SUMMARY OF INVENTION

TECHNICAL PROBLEM

An object of the present invention is to provide a composition that contains quantum dots and is capable of forming a film having favorable patterning characteristics and light-emitting characteristics. Another object of the present invention is to provide a film formed from the composition, and a display device containing the film.

SOLUTION TO PROBLEM

The present invention provides a composition, a film, and a display device shown below.

[1] A composition comprising: a quantum dot (A) and a vinyl copolymer (B),

wherein the vinyl copolymer (B) has:

a structural unit derived from (meth)acrylic acid,
a structural unit derived from (meth)acrylate having a carboxy group, and
a structural unit derived from (meth)acrylate having no carboxy group;

contains a tellurium compound;
has a molecular weight distribution of 2.0 or less; and
has an acid value of 100 mgKOH/g to 150 mgKOH/g.

[2] The composition according to [1], wherein the vinyl copolymer (B) has structural units derived from monomers represented by a formula (I), a formula (II), and a formula (III):

[Formula 1]

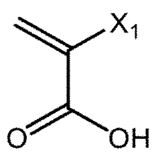

(I)

[in the formula (I), $X_1$ represents a hydrogen atom or a methyl group];

[Formula 2]

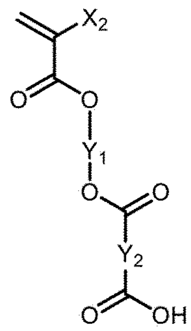

(I I)

[in the formula (II), $X_2$ represents a hydrogen atom or a methyl group, $Y_1$ represents a linear, branched, or cyclic hydrocarbon group having 1 to 6 carbon atoms, and $Y_2$ represents a linear, branched, or cyclic hydrocarbon group having 1 to 6 carbon atoms];

[Formula 3]

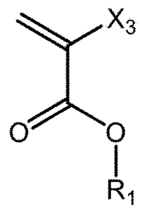

(I I I)

[in the formula (III), $X_3$ represents a hydrogen atom or a methyl group, and $R_1$ represents a linear, branched, or cyclic hydrocarbon group having 1 to 30 carbon atoms.].

[3] The composition according to [1] or [2], wherein the vinyl copolymer (B) further has a structural unit having an ultraviolet curable functional group.

[4] The composition according to any one of [1] to [3], wherein the vinyl copolymer (B) has an ethylenic unsaturated bond equivalent being a weight-average molecular weight per mole of ethylenic unsaturated bond of more than 1000 and 8000 or less.

[5] The composition according to any one of [1] to [4], wherein a content of the tellurium compound in the vinyl copolymer (B) is more than 0 ppm and 350 ppm or less in terms of metal tellurium.

[6] The composition according to any one of [1] to [5], further comprising a polymerizable compound (C) and a polymerization initiator (D).

[7] The composition according to any one of [1] to [6], further comprising a solvent (E).

[8] The composition according to any one of [1] to [7], wherein the quantum dot (A) is at least one selected from the group consisting of a compound of a group 12 element and a group 16 element, a compound of a group 13 element and a group 15 element, a compound of a group 13 element and a group 16 element, and a compound of a group 14 element and a group 16 element.

[9] The composition according to any one of [1] to [8], wherein a content of the quantum dot (A) is 50 parts by mass to 350 parts by mass based on 100 parts by mass of the vinyl copolymer (B).

[10] A film formed from the composition according to any one of [1] to [9].

[11] A display device comprising the film according to [10].

ADVANTAGEOUS EFFECTS OF INVENTION

It is possible to provide a composition that contains quantum dots and is capable of forming a film having favorable patterning characteristics and light-emitting characteristics, a film formed from the composition, and a display device containing the film.

DESCRIPTION OF EMBODIMENTS

<Composition>

The composition according to the present invention (hereinafter, also simply referred to as "composition") comprises: a quantum dot (A) and a specific vinyl copolymer (B), which will be described later. The composition may further contain another component such as a polymerizable compound (C), a polymerization initiator (D), or a solvent (E). The composition may be a curable composition that is cured by irradiation of light or heat.

According to the composition according to the present invention, a film having favorable patterning characteristics and light-emitting characteristics can be formed. The composition is preferably capable of favorably forming a film having a line-and-space pattern with a width of 20 μm. The composition is preferably capable of forming a film having a favorable quantum yield QY and/or external quantum efficiency EQE, and is more preferably capable of forming a film having a favorable quantum yield QY and external quantum efficiency EQE. Furthermore, according to the composition according to the present invention, a film having favorable patterning characteristics and light-emitting characteristics, and having a favorable appearance can be formed. The favorable appearance refers to a state where aggregates are not present in a coating film or sufficiently reduced, and specifically refers to a state where no foreign materials are found when the appearance is evaluated by the method described in Examples later.

As used herein, the meanings of the following terms are as follows.

"(Meth)acrylic acid" means at least one of acrylic acid and methacrylic acid. Similarly, "(meth)acryloyloxy" means at least one of acryloyloxy and methacryloyloxy, and "(meth)acryloyl" means at least one of acryloyl and methacryloyl.

"(Meth)acrylate" means an ester compound in which a hydrogen atom in a carboxy group in (meth)acrylic acid is substituted with a hydrocarbon group.

The "vinyl copolymer" means a copolymer of two or more vinyl monomers. The "vinyl monomer" means a monomer having a polymerizable vinyl group (ethylenic unsaturated double bond), and includes a monomer having a (meth)acryloyl group and a monomer having an allyl group.

"Blue" generally refers to light visually recognized as blue color (generally, light having an intensity within the wavelength range of blue color, for example, the range 380 nm or more and 495 nm or less), and not limited to light having a single wavelength.

"Green" generally refers to light visually recognized as green color (generally, light having an intensity within the wavelength range of green color, for example, the range 495 nm or more and 585 nm or less), and not limited to light having a single wavelength.

"Red" generally refers to light visually recognized as red color (generally, light having an intensity within the wavelength range of red color, for example, the range 585 nm or more and 780 nm or less), and not limited to light having a single wavelength.

"Yellow" generally refers to light visually recognized as yellow color (generally, light having an intensity within the wavelength range of yellow color, for example, the range 560 nm or more and 610 nm or less), and not limited to light having a single wavelength.

Components that are included or may be included in the composition will be described below. Herein, compounds listed as a component that is included or may be included in the composition can be used singly or in combinations of two or more, unless otherwise noticed.

[1] Quantum dot (A)

The quantum dot (A) is a light emissive semiconductor fine particle having a particle size of 1 nm or more and 100 nm or less, and is a fine particle that utilizes the bandgap of the semiconductor to absorb ultraviolet or visible light (e.g., blue light) and emit light. The quantum dot (A) preferably emits green or red light, and more preferably absorbs blue light to emit green or red light.

The light emission spectrum of the quantum dot (A) that emits green preferably exhibits a peak having the maximum value within a wavelength range of 500 nm or more and 560 nm or less, more preferably a peak having the maximum value within a wavelength range of 520 nm or more and 545 nm or less, and even more preferably a peak having the maximum value within a wavelength range of 525 nm or more and 535 nm or less. This enables the light-emitting characteristics of green light of the display device to be more improved. The peak preferably has a full width at half maximum of 15 nm or more and 80 nm or less, more preferably 15 nm or more and 60 nm or less, even more preferably 15 nm or more and 50 nm or less, particularly preferably 15 nm or more and 45 nm or less. This enables the light-emitting characteristics of green light of the display device to be more improved.

The light emission spectrum of the quantum dots (A) emitting red light preferably exhibits a peak having the maximum value within a wavelength range of 610 nm or more and 750 nm or less, more preferably a peak having the maximum value within a wavelength range of 620 nm or more and 650 nm or less, even more preferably a peak having the maximum value within a wavelength range of 625 nm or more and 645 nm or less. This enables the light-emitting characteristics of red light of the display device to be more improved. The peak preferably has a full width at half maximum

of 15 nm or more and 80 nm or less, more preferably 15 nm or more and 60 nm or less, even more preferably 15 nm or more and 50 nm or less, particularly preferably 15 nm or more and 45 nm or less. This enables the light-emitting characteristics of red light of the display device to be more improved.

The light emission spectrum of the quantum dot (A) is measured according to the method described in the section of Examples later.

For example, the quantum dot (A) can be constituted from a semiconductor material containing one or two or more kinds of elements selected from the group consisting of a group 2 element, a group 11 element, a group 12 element, a group 13 element, a group 14 element, a group 15 element, and a group 16 element of the periodic table.

Specific examples of the semiconductor material that may constitute the quantum dot include:

a compound of a group 14 element and a group 16 element such as $SnS_2$, SnS, SnSe, SnTe, PbS, PbSe, and PbTe;
a compound of a group 13 element and a group 15 element such as GaN, GaP, GaAs, GaSb, InN, InP, InAs, InSb, InGaN, and InGaP;
a compound of a group 13 element and a group 16 element such as $Ga_2O_3$, $Ga_2S_3$, $Ga_2Se_3$, $Ga_2Te_3$, $In_2O_3$, $In_2S_3$, $In_2Se_3$, $In_2Te_3$, and AgInGaS;
a compound of a group 12 element and a group 16 element such as ZnO, ZnS, ZnSe, ZnTe, CdO, CdS, CdSe, CdTe, HgO, HgS, HgSe, HgTe, ZnSTe, ZnSeS, ZnSeTe, CdSTe, CdSeTe, HgSTe, HgSeS, and HgSeTe;
a compound of a group 15 element a group 16 element such as $As_2O_3$, $As_2S_3$, $As_2Se_3$, $As_2Te_3$, $Sb_2O_3$, $Sb_2S_3$, $Sb_2Se_3$, $Sb_2Te_3$, $Bi_2O_3$, $Bi_2S_3$, $Bi_2Se_3$, and $Bi_2Te_3$;
a compound of a group 2 element a group 16 element such as MgS, MgSe, MgTe, CaS, CaSe, CaTe, SrS, SrSe, SrTe, BaS, BaSe, and BaTe; and
an elementary substance of a group 14 element, a group 15 element or a group 16 element, such as Si and Ge.

Among these, since the light-emitting characteristics tend to be favorable, the quantum dot (A) is preferably at least one selected from the group consisting of a compound of a group 12 element and a group 16 element, a compound of a group 13 element and a group 15 element, a compound of a group 13 element and a group 16 element, and a compound of a group 14 element and a group 16 element.

In a case where quantum dots including S or Se is used, the quantum dots optionally have a surface modified with a metal oxide or an organic matter. When quantum dots having a modified surface are used, S or Se abstraction by a reactive component that is contained or may be contained in the composition can be prevented.

The above-described compounds may be combined to form quantum dots (A) having a core-shell structure. Examples of such a combination include a fine particle including CdSe as the core and ZnS as the shell, and a fine particle including InP as the core and ZnSeS as the shell.

Since the energy state of the quantum dots (A) depends on its size, the emission wavelength can be freely selected by changing the particle size. The light emitted from the quantum dots (A) has a spectrum having a narrow range, which is advantageous for expansion of the color gamut of a display device. Furthermore, the quantum dots (A) have high responsibility, which is advantageous for efficiency of utilization of primary light.

The composition may contain two or more kinds of the quantum dots (A). For example, the composition may contain only a single kind of quantum dots (A) that absorbs primary light to emit green light, or may contain two or more kinds thereof in combination. The composition may contain only a single kind of the quantum dots (A) that absorbs primary light to emit red light, or may contain two or more kinds thereof in combination.

The content ratio of the quantum dot (A) in the composition is, for example, 1% by mass or more, preferably 10% by mass or more, more preferably 15% by mass or more, even more preferably 20% by mass or more, and, for example, 60% by mass or less, preferably 50% by mass or less, more preferably 40% by mass or less, based on the total amount of the solids content of the composition.

The total amount of the solids content of the composition means the total components excluding the solvent (E) among the components contained in the composition. The content ratio in the solids content of the composition can be measured by known analytical means such as liquid chromatography or gas chromatography. The content ratio of each component in the solids content of the composition may also be calculated from the formulation when the composition is prepared.

The content of the quantum dot (A) in the composition is, for example, 50 parts by mass or more, preferably 55 parts by mass or more, more preferably 60 parts by mass or more, even more preferably 70 parts by mass or more, and for example, 350 parts by mass or less, preferably 250 parts by mass or less, more preferably 200 parts by mass or less, even more preferably 150 parts by mass or less, based on 100 parts by mass of the vinyl copolymer (B).

When the composition contains two or more kinds of the quantum dots (A), the content ratio or content of the quantum dot (A) means the total content ratio or total content of two or more kinds of the quantum dots (A). The same also applies to components other than the quantum dot (A) that are contained or may be contained in the composition, which will be described later.

[2] Organic ligand (G)

The composition can further contain an organic ligand (G), and the quantum dot (A) may be present in the composition while being coordinated with the organic ligand (G). The organic ligand (G) may be, for example, an organic compound having a polar group having capability to coordinate with the quantum dots (A). The organic ligand (G) may coordinate to the surface of the quantum dots (A), for example. The composition may contain one or two or more kinds of the organic ligands (G).

**In** the composition, at least some molecules of the organic ligand (G) are preferably coordinated with the quantum dots (A), and all or almost all molecules of the organic ligand (G) may be coordinated with the quantum dots (A). Containing the organic ligand (G) coordinated with the quantum dot (A) can be advantageous for improving stability and dispersibility of the quantum dot (A) and the light-emitting characteristics of the film.

The polar group of the organic ligand (G) is at least one group selected from the group consisting of a thiol group (-SH), a carboxy group (-COOH), and an amino group ($-NH_2$). The polar group selected from the group can be advantageous in increasing the coordination property to the quantum dots (A). The larger coordination property can contribute to the improvement in stability and dispersibility of the quantum dot (A) in the composition and the improvement in the light-emitting characteristics of the film. In particular, the polar group is more preferably at least one group selected from the group consisting of a thiol group and a carboxy group. The organic ligand (G) may have one or two or more polar groups.

The organic ligand (G) may be, for example, an organic compound represented by the following formula (x):

$$X^A\text{-}R^X \qquad (x)$$

In the formula, $X^A$ is the above-mentioned polar group, and $R^X$ is a monovalent hydrocarbon group which may contain a heteroatom (N, O, S, halogen atom, or the like). The hydrocarbon group may have one or two or more unsaturated bonds such as carbon-carbon double bonds. The hydrocarbon group may have a linear, branched, or cyclic structure. The number of carbon atoms of the hydrocarbon group is, for example, 1 or more and 40 or less, and may be 1 or more and 30 or less. The methylene group contained in the hydrocarbon group is optionally replaced by -O-, -S-, -C(=O)-, -C(=O)-O-, -O-C(=O)-, -C(=O)-NH-, -NH-, or the like.

The group $R^X$ may contain a polar group. With respect to specific examples of the polar group, the above description relating to the polar group $X^A$ is referred to.

Specific examples of the organic ligand having a carboxy group as the polar group $X^A$ include formic acid, acetic acid, propionic acid, and saturated or unsaturated fatty acids. Specific examples of saturated or unsaturated fatty acids include saturated fatty acids such as butyric acid, pentanoic acid, caproic acid, caprylic acid, capric acid, lauric acid, myristic acid, pentadecylic acid, palmitic acid, margaric acid, stearic acid, arachidic acid, behenic acid, and lignoceric acid; monounsaturated fatty acids such as myristoleic acid, palmitoleic acid, oleic acid, icosenoic acid, erucic acid, and nervonic acid; and polyunsaturated fatty acids such as linoleic acid, α-linolenic acid, γ-linolenic acid, stearidonic acid, dihomo-γ-linolenic acid, arachidonic acid, eicosatetraenoic acid, docosadienoic acid, and adrenic acid (docosatetraenoic acid).

Specific examples of the organic ligand having a thiol group or an amino group as the polar group $X^A$ include organic ligands in which the carboxy group of the organic ligands having a carboxy group as the polar group $X^A$ exemplified above is replaced by a thiol group or an amino group.

In addition to the above, examples of the organic ligand represented by the formula (x) include a compound (G-1) and a compound (G-2).

[Compound (G-1)]

The compound (G-1) is a compound having the first functional group and the second functional group. The first functional group is a carboxy group (-COOH), and the second functional group is a carboxy group or thiol group (-SH). Since the compound (G-1) has a carboxy group and/or a thiol group, it may serve as a ligand to coordinate with the quantum dot (A). The composition may contain only a single kind of the compound (G-1) or two or more thereof.

An example of the compound (G-1) is a compound represented by the formula (G-1a) below. The compound (G-1) may be an acid anhydride of the compound represented by the formula (G-1a).

[Formula 4]

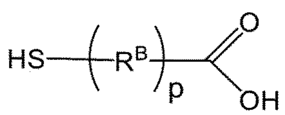

(G-1a)

[In the formula, $R^B$ represents a divalent hydrocarbon group. A plurality of $R^B$, when present, may be the same or different. The hydrocarbon group may have one or more substituents. When there are a plurality of substituents, they may be the same or different, and they may be bonded to each other to form a ring together with the atoms to which they are bonded. $-CH_2-$ contained in the hydrocarbon group is optionally replaced by at least one of -O-, -S-, $-SO_2-$, -CO-, and -NH-. p represents an integer of 1 or more and 10 or less.]

Examples of the divalent hydrocarbon group represented by $R^B$ include a chain hydrocarbon group, an alicyclic hydrocarbon group, and an aromatic hydrocarbon group.

Examples of the chain hydrocarbon group include a linear or branched alkanediyl group, and the number of carbon atoms thereof is generally 1 or more and 50 or less, preferably 1 or more and 20 or less, and more preferably 1 or more and 10 or less. Examples of the alicyclic hydrocarbon group include a monocyclic or polycyclic cycloalkanediyl group, and the number of carbon atoms thereof is usually 3 or more and 50 or less, preferably 3 or more and 20 or less, and more preferably 3 or more and 10 or less. Examples of the aromatic hydrocarbon group include a monocyclic or polycyclic arenediyl group, and the number of carbon atoms thereof is generally 6 or more and 20 or less.

Examples of the substituent that the hydrocarbon group may have include an alkyl group having 1 or more and 50 or less carbon atoms, a cycloalkyl group having 3 or more and 50 or less carbon atoms, an aryl group having 6 or more and 20 or less carbon atoms, a carboxy group, an amino group, and a halogen atom. The substituent that the hydrocarbon group may have is preferably a carboxy group, an amino group, or a halogen atom.

When-$CH_2$- contained in the hydrocarbon group is replaced by at least one of - O-, -CO-, and -NH-, $-CH_2-$ is preferably replaced by at least one of -CO- and -NH-, and more preferably -NH-. p is preferably 1 or 2.

Examples of the compound represented by the formula (G-1a) include compounds represented by the following formulas (1-1) to (1-9).

[Formula 5]

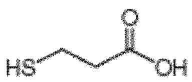 (1-1)

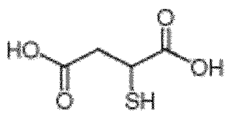 (1-2)

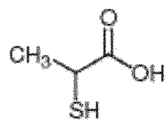 (1-3)

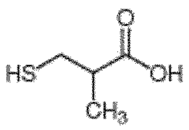 (1-4)

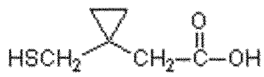 (1-5)

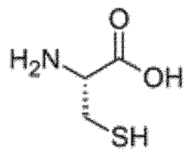 (1-6)

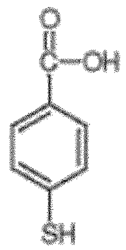 (1-7)

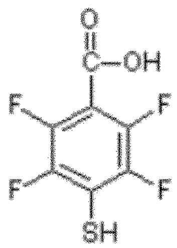 (1-8)

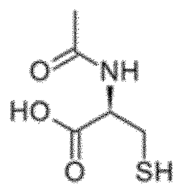 (1-9)

Specific examples of the compound represented by the formula (G-1a) include mercaptoacetic acid, 2-mercaptopropionic acid, 3-mercaptopropionic acid, 3-mercaptobutanoic acid, 4-mercaptobutanoic acid, mercaptosuccinic acid, mercaptostearic acid, mercaptooctanoic acid, 4-mercaptobenzoic acid, 2,3,5,6-tetrafluoro-4-mercaptobenzoic acid, L-cysteine, N-acetyl-L-cysteine, 3-methoxybutyl 3-mercaptopropionate, and 3-mercapto-2-methylpropionic acid. Of these, 3-mercaptopropionic acid and mercaptosuccinic acid are preferable.

Another example of the compound (G-1) is a polycarboxylic acid compound, preferably a compound (G-1b) in which -SH in the formula (G-1a) is replaced by a carboxy group (-COOH) in the compound represented by the formula (G-1a).

Examples of the compound (G-1b) include the following compounds:

Succinic acid, glutaric acid, adipic acid, octafluoroadipic acid, azelaic acid, dodecanedioic acid, tetradecanedioic acid, hexadecanedioic acid, heptadecanedioic acid, octadecanedioic acid, nonadecandioic acid, dodecafluorosuberic acid, 3-ethyl-3-methylglutaric acid, hexafluoroglutaric acid, trans-3-hexenedioic acid, sebacic acid, hexadecafluorosebacic acid, acetylenedicarboxylic acid, trans-aconitic acid, 1,3-adamantandicarboxylic acid, bicyclo[2.2.2]octane-1,4-dicarboxylic acid, cis-4-cyclohexene-1,2-dicarboxylic acid, 1,1-cyclopropanedicarboxylic acid, 1,1-cyclobutanedicarboxylic acid, cis- or trans-1,3-cyclohexanedicarboxylic acid, cis- or trans-1,4-cyclohexanedicarboxylic acid, 1,1-cyclopentanediacetic acid, 1,2,3,4-cyclopentanetetracarboxylic acid, decahydro-1,4-naphthalenedicarboxylic acid, 2,3-norbornanedicarboxylic

acid, 5-norbornene-2,3-dicarboxylic acid, phthalic acid, 3-fluorophthalic acid, isophthalic acid, tetrafluoroisophthalic acid, terephthalic acid, tetrafluoroterephthalic acid, 2,5-dimethylterephthalic acid, 2,6-naphthalenedicarboxylic acid, 2,3-naphthalenedicarboxylic acid, 1,4-naphthalenedicarboxylic acid, 1,1'-ferrocenedicarboxylic acid, 2,2'-biphenyldicarboxylic acid, 4,4'-biphenyldicarboxylic acid, 2,5-furandicarboxylic acid, benzophenone-2,4'-dicarboxylic acid monohydrate, benzophenone-4,4'-dicarboxylic acid, 2,3-pyrazinedicarboxylic acid, 2,3-pyridinedicarboxylic acid, 2,4-pyridinedicarboxylic acid, 3,5-pyridinedicarboxylic acid, 2,5-pyridinedicarboxylic acid, 2,6-pyridinedicarboxylic acid, 3,4-pyridinedicarboxylic acid, pyrazole-3,5-dicarboxylic acid monohydrate, 4,4'-stilbenedicarboxylic acid, anthraquinone-2,3-dicarboxylic acid, 4-(carboxymethyl)benzoic acid, chelidonic acid monohydrate, azobenzene-4,4'-dicarboxylic acid, azobenzene-3,3'-dicarboxylic acid, chlorendic acid, 1H-imidazole-4,5-dicarboxylic acid, 2,2-bis(4-carboxyphenyl)hexafluoropropane, 1,10-bis(4-carboxyphenoxy)decane, dipropylmalonic acid, dithiodiglycolic acid, 3,3'-dithiodipropionic acid, 4,4'-dithiodibutanoic acid, 4,4'-dicarboxydiphenyl ether, 4,4'-dicarboxydiphenyl sulfone, ethylene glycol bis(4-carboxyphenyl)ether, 3,4-ethylenedioxythiophene-2,5-dicarboxylic acid, 4,4'-isopropylidenediphenoxyacetic acid, 1,3-acetonedicarboxylic acid, methylenedisalicylic acid, 5,5'-thiodisalicylic acid, tris(2-carboxyethyl)isocyanurate, tetrafluorosuccinic acid, $\alpha,\alpha,\alpha',\alpha'$-tetramethyl-1,3-benzenedipropionic acid, and 1,3,5-benzenetricarboxylic acid.

From the viewpoint of improving stability and dispersibility of the quantum dots (A) and the light-emitting characteristics of a film, the molecular weight of the compound (G-1) is preferably 3000 or less, more preferably 2500 or less, even more preferably 2000 or less, still more preferably 1000 or less, particularly preferably 800 or less, and most preferably 500 or less. The molecular weight of the compound (G-1) is generally 100 or more.

The molecular weight may be a number-average molecular weight or a weight-average molecular weight. In this case, the number-average molecular weight and the weight-average molecular weight are a number-average molecular weight and a weight-average molecular weight in terms of standard polystyrene measured by gel permeation chromatography (GPC), respectively.

In the case where the composition contains the compound (G-1), the ratio of the content of the compound (G-1) to the quantum dot (A) in the composition is preferably 0.001 or more, more preferably 0.01 or more, even more preferably 0.02 or more, and preferably 1 or less, more preferably 0.5 or less, even more preferably 0.45 or less, in terms of mass ratio. The ratio between these contents within this range can be advantageous for improving stability and dispersibility of the quantum dot (A) and the light-emitting characteristics of the film.

In the case where the composition contains the compound (G-1), the content ratio of the compound (G-1) in the composition is preferably 0.1% by mass or more, more preferably 0.2% by mass or more, even more preferably 0.5% by mass or more, and preferably 20% by mass or less, more preferably 10% by mass or less, even more preferably 8% by mass or less, based on the total amount of the solids content of the composition, from the viewpoint of improving stability and dispersibility of the quantum dot (A) and the light-emitting characteristics of the film.

[Compound (G-2)]

The compound (G-2) is a compound different from the compound (G-1), and is a compound having a polyalkylene glycol structure and having a polar group at the molecular end. The molecular end is preferably the end of the longest carbon chain in the compound (G-2) (the carbon atom in the carbon chain is optionally replaced by another atom such as an oxygen atom).

The composition may contain only one compound (G-2) or two or more kinds thereof. The composition may contain the compound (G-1) or the compound (G-2), or may contain the compound (G-1) and the compound (G-2). Compounds having a polyalkylene glycol structure and having the first functional group and the second functional group are considered to belong to the compound (G-1).

The polyalkylene glycol structure refers to a structure represented by the following formula:

[0053] [Formula 6]

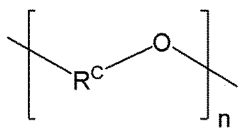

wherein n is an integer of 2 or more. In the formula, $R^C$ is an alkylene group, and examples thereof include an ethylene group and a propylene group.

Specific examples of the compound (G-2) include a polyalkylene glycol compound represented by the formula (G-2a) below.

[Formula 7]

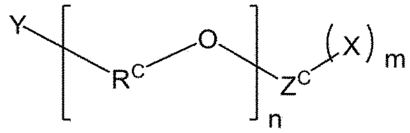

(G-2a)

In the formula (G-2a), X is a polar group, Y is a monovalent group, and $Z^C$ is a divalent or trivalent group. n is an integer of 2 or more. m is 1 or 2. $R^C$ is an alkylene group.

The polar group X is preferably at least one group selected from the group consisting of a thiol group (-SH), a carboxy group (-COOH), and an amino group ($-NH_2$). The polar group selected from the above-described group may be advantageous in terms of enhancing capability to coordinate with the quantum dots (A). Among these, the polar group X is more preferably at least one group selected from the group consisting of a thiol group and a carboxy group in view of improving the stability and dispersibility of the quantum dots (A) and the light-emitting characteristics of the film.

The group Y is a monovalent group. The group Y is not particularly limited, and examples thereof include a monovalent hydrocarbon group optionally having a substituent (N, O, S, a halogen atom, etc.). $-CH_2-$ contained in the hydrocarbon group is optionally replaced by -O-, -S-, -C(=O)-, -C(=O)-O-, -O-C(=O)-, -C(=O)-NH-, -NH-, or the like. The number of carbon atoms of the hydrocarbon group is, for example, 1 or more and 12 or less. The hydrocarbon group may have an unsaturated bond.

Examples of the group Y include an alkyl group having a linear, branched, or cyclic structure having 1 or more and 12 or less carbon atoms; and an alkoxy group having a linear, branched, or cyclic structure having 1 or more and 12 or less carbon atoms. The number of carbon atoms of the alkyl group and the alkoxy group is preferably 1 or more and 8 or less, more preferably 1 or more and 6 or less, and still more preferably 1 or more and 4 or less. $-CH_2-$ contained in the alkyl group and the alkoxy group is optionally replaced by -O-, -S-, -C(=O)-, -C(=O)-O-, -O-C(=O)-, - C(=O)-NH-, -NH-, or the like. In particular, the group Y is preferably a linear or branched alkoxy group having 1 or more and 4 or less carbon atoms, and more preferably a linear alkoxy group having 1 or more and 4 or less carbon atoms.

The group Y may contain a polar group. Examples of the polar group include at least one group selected from the group consisting of a thiol group (-SH), a carboxy group (-COOH), and an amino group ($-NH_2$). However, as described above, compounds having a polyalkylene glycol structure and having the first functional group and the second functional group are considered to belong to the compound (G-1). The polar group is preferably located at the end of the group Y.

The group $Z^C$ is a divalent or trivalent group. The group $Z^C$ is not particularly limited, and examples thereof include a divalent or trivalent hydrocarbon group which may contain a heteroatom (N, O, S, halogen atom, or the like). The number of carbon atoms of the hydrocarbon group is, for example, 1 or more and 24 or less. The hydrocarbon group may have an unsaturated bond.

Examples of the group $Z^C$ which is a divalent group include an alkylene group having a linear, branched, or cyclic structure having 1 or more and 24 or less carbon atoms; and an alkenylene group having a linear, branched, or cyclic structure having 1 or more and 24 or less carbon atoms. The number of carbon atoms of the alkylene group and the alkenylene group is preferably 1 or more and 12 or less, more preferably 1 or more and 8 or less, and still more preferably 1 or more and 4 or less. $-CH_2-$contained in the alkylene group and the alkenylene group is optionally replaced by -O-, -S-, -C(=O)-, -C(=O)-O-, -O-C(=O)-, -C(=O)-NH-, -NH-, or the like. Examples of the group $Z^C$ which is a trivalent group include a group obtained by removing one hydrogen atom from the group $Z^C$ which is a divalent group described above.

The group $Z^C$ may have a branched structure. The group $Z^C$ having a branched structure may have a polyalkylene glycol structure different from the polyalkylene glycol structure represented by the formula (G-2a) in a branched chain different from the branched chain including the polyalkylene glycol structure represented by the formula (G-2a).

In particular, the group $Z^C$ is preferably a linear or branched alkylene group having 1 or more and 6 or less carbon atoms, and more preferably a linear alkylene group having 1 or more and 4 or less carbon atoms.

$R^C$ is an alkylene group, and is preferably a linear or branched alkylene group having 1 or more and 6 or less carbon atoms, and more preferably a linear alkylene group having 1 or more and 4 or less carbon atoms.

n in the formula (G-2a) is an integer of 2 or more, preferably 2 or more and 540 or less, more preferably 2 or more and 120 or less, and still more preferably 2 or more and 60 or less.

The molecular weight of the compound (G-2) can be, for example, about 150 or more and about 10000 or less, and is preferably 150 or more and 5000 or less, and more preferably 150 or more and 4000 or less, from the viewpoint of improving stability and dispersibility of the quantum dots (A) and the light-emitting characteristics of a film. The molecular weight may be a number-average molecular weight or a weight-average molecular weight. In this case, the number-average molecular weight and the weight-average molecular weight are a number-average molecular weight and a weight-average molecular weight in terms of standard polystyrene measured by GPC, respectively.

In the case where the composition contains the compound (G-2), the ratio of the content of the compound (G-2) to the quantum dot (A) in the composition is preferably 0.001 or more, more preferably 0.01 or more, even more preferably 0.1 or more, and preferably 2 or less, more preferably 1.5 or less, even more preferably 1 or less, in terms of mass ratio. The ratio between these contents within this range can be advantageous for improving stability and dispersibility of the quantum dot (A) and the light-emitting characteristics of the film.
In the case where the composition contains the compound (G-2), the content ratio of the compound (G-2) in the composition is preferably 0.1% by mass or more, more preferably 1% by mass or more, even more preferably 2% by mass or more, and preferably 40% by mass or less, more preferably 20% by mass or less, even more preferably 15% by mass or less, even more preferably 12% by mass or less, based on the total amount of the solids content of the composition, from the viewpoint of improving stability and dispersibility of the quantum dot (A) and the light-emitting characteristics of the film.
In the case where the composition contains the organic ligand (G), the ratio of the content of the organic ligand (G) to the quantum dot (A) in the composition is preferably 0.001 or more, more preferably 0.01 or more, even more preferably 0.02 or more, and preferably 1 or less, more preferably 0.8 or less, even more preferably 0.5 or less, in terms of mass ratio. The ratio between these contents within this range can be advantageous for improving stability and dispersibility of the quantum dot (A) and the light-emitting characteristics of the film. The content of the organic ligand (G) here means the total content of all the organic ligand(s) contained in the composition.
The total content ratio of the quantum dot (A) and the organic ligand (G) in the composition is preferably 10% by mass or more, more preferably 12% by mass or more, even more preferably 15% by mass or more, and preferably 75% by mass or less, more preferably 70% by mass or less, even more preferably 65% by mass or less, based on the total amount of the solids content of the composition, from the viewpoint of improving stability and dispersibility of the quantum dot (A) and the light-emitting characteristics of the film.

[3] Vinyl copolymer (B)

The vinyl copolymer (B) has a structural unit (B-1) derived from (meth)acrylic acid (hereinafter, also referred to as "monomer (b-1)"), a structural unit (B-2) derived from (meth)acrylate having a carboxy group (hereinafter, also referred to as "monomer (b-2)"), and a structural unit (B-3) derived from (meth)acrylate having no carboxy group (hereinafter, also referred to as "monomer (b-3)").
The composition may contain two or more kinds of the vinyl copolymers (B).
The vinyl copolymer (B) satisfies the followings.

- The vinyl copolymer (B) contains a tellurium compound.
- The vinyl copolymer (B) has a molecular weight distribution of 2.0 or less.
- The vinyl copolymer (B) has an acid value of 100 mgKOH/g or more and 150 mgKOH/g or less.

According to the composition containing the vinyl copolymer (B), a film having favorable patterning characteristics and light-emitting characteristics can be formed. One of the factors for favorable patterning characteristics is a narrow molecular weight distribution of the vinyl copolymer (B). It is considered that the narrow molecular weight distribution enables a boundary between a pattern area and a space area to be clear upon development, even with a fine pattern shape. The narrow molecular weight distribution can also be advantageous in increasing the solvent resistance and heat resistance of the film formed from the composition and the pot life (stability with time) of the composition. Another factor for enabling a film having favorable light-emitting characteristics to be formed is the vinyl copolymer (B) containing a tellurium compound.
According to the composition containing the vinyl copolymer (B), the dispersibility of the quantum dot (A) in the composition and the film formed therefrom can be improved, and this can increase the light-emitting characteristics of the film. In addition, since the dispersibility of the quantum dot (A) can be improved, it is possible to increase the content of the quantum dot (A) in the composition and the film to be formed (increase the concentration of the quantum dot (A)). This means that, even when the thickness of the film is made thinner, light-emitting characteristics equivalent to or higher than before can be exhibited. Examples of the factors for enabling the dispersibility of the quantum dot (A) to be improved include the acid value of the vinyl copolymer (B) within the above-described range, the narrow molecular weight distribution of the vinyl copolymer (B), and a specific structure of the vinyl copolymer (B) including monomer species constituting the vinyl copolymer (B).
Furthermore, since the dispersibility of the quantum dot (A) can be improved according to the composition containing the vinyl copolymer (B), a film excellent in the appearance having low aggregates or no aggregates can be formed.
The monomer (b-1) which is one of the monomers forming the vinyl copolymer (B) is (meth)acrylic acid and is represented by the following formula (I). In the formula (I), $X_1$ represents a hydrogen atom or a methyl group.

[Formula 8]

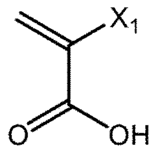

( I )

The monomer (b-2) which is another monomer forming the vinyl copolymer (B) is (meth)acrylate having a carboxy group, and examples thereof include a monomer represented by the following formula (II).

[Formula 9]

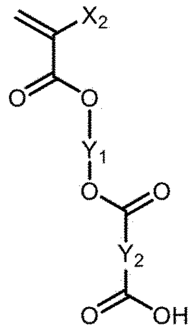

( I I )

In the formula (II), $X_2$ represents a hydrogen atom or a methyl group. $Y_1$ represents a linear, branched, or cyclic hydrocarbon group having 1 or more and 6 or less carbon atoms. $Y_2$ represents a linear, branched, or cyclic hydrocarbon group having 1 or more and 6 or less carbon atoms. At least one $-CH_2-$ in these hydrocarbon groups may be substituted with -C(=O)-, -O-, -S-, -NH-, or the like.

The number of carbon atoms of the hydrocarbon group represented by $Y_1$ is preferably 1 or more and 4 or less, and more preferably 1 or more and 3 or less. For example, the hydrocarbon group represented by $Y_1$ and the hydrocarbon group represented by $Y_2$ are each independently an alkylene group, a divalent aromatic group, or a divalent alicyclic group.

Specific examples of the monomer represented by the formula (II) include 2-methacryloyloxyethyl succinate, 2-acryloyloxyethyl succinate, mono-2-(methacryloyloxy)ethyl phthalate, mono-2-(acryloyloxy)ethyl phthalate, 2-(methacryloyloxy)ethyl hydrogen hexahydrophthalate, and 2-(acryloyloxy)ethyl hydrogen hexahydrophthalate.

The monomer (b-3) which is the other monomer forming the vinyl copolymer (B) is (meth)acrylate having no carboxy group, and examples thereof include a monomer represented by the following formula (III).

[Formula 10]

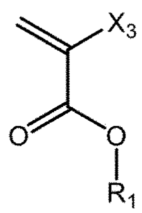

( I I I )

In the formula (III), $X_3$ represents a hydrogen atom or a methyl group. $R_1$ represents a linear, branched, or cyclic hydrocarbon group having 1 or more and 30 or less carbon atoms. At least one $-CH_2-$ in the hydrocarbon group may be substituted with -C(=O)-, -O-, -S-, -NH-, or the like. The number of carbon atoms of the hydrocarbon group represented by $R_1$ is preferably 1 or more and 20 or less, more preferably 1 or more and 12 or less, and even more preferably 1 or more and 6 or less. For example, the hydrocarbon group represented by $R_1$ is each independently an alkyl group, a monovalent aromatic group, or a monovalent alicyclic group.

Specific examples of the monomer (b-3) include (meth)acrylic esters such as methyl (meth)acrylate, ethyl (meth) acrylate, n-butyl (meth)acrylate, sec-butyl (meth)acrylate, tert-butyl (meth)acrylate, 2-ethylhexyl (meth)acrylate, dodecyl (meth)acrylate, lauryl (meth)acrylate, stearyl (meth)acrylate, cyclopentyl (meth)acrylate, cyclohexyl (meth)acrylate, 2-methylcyclohexyl (meth)acrylate, tricyclo[5.2.1.0$^{2,6}$]decan-8-yl (meth)acrylate (referred to as "dicyclopentanyl (meth) acrylate" (common name) in the art or sometimes referred to as "tricyclodecyl (meth)acrylate"), tricyclo[5.2.1.0$^{2,6}$]

decen-8-yl (meth)acrylate (which is referred to as "dicyclopentenyl (meth)acrylate" (common name) in the art), dicyclopentanyloxyethyl (meth)acrylate, isobornyl (meth)acrylate, adamantyl (meth)acrylate, allyl (meth)acrylate, propargyl (meth)acrylate, phenyl (meth)acrylate, naphthyl (meth)acrylate, and benzyl (meth)acrylate; hydroxy group-containing (meth)acrylic esters such as 2-hydroxyethyl (meth)acrylate and 2-hydroxypropyl (meth)acrylate.

From the viewpoint of improving the patterning characteristics, light-emitting characteristics, and the like of the film, the vinyl copolymer (B) preferably has structural units derived from monomers represented by the formula (I), the formula (II), and the formula (III).

The content ratio of the structural unit (B-1) derived from the monomer (b-1) in the vinyl copolymer (B) is preferably 2 mol% or more, more preferably 5 mol% or more, even more preferably 10 mol% or more, and preferably 60 mol% or less, more preferably 50 mol% or less, even more preferably 40 mol% or less, based on 100 mol% of the total structural units.

The content ratio of the structural unit (B-2) derived from the monomer (b-2) is preferably 1 mol% or more, more preferably 2 mol% or more, even more preferably 5 mol% or more, and preferably 50 mol% or less, more preferably 40 mol% or less, even more preferably 30 mol% or less, based on 100 mol% of the total structural units.

The content ratio of the structural unit (B-3) derived from the monomer (b-3) is preferably 10 mol% or more, more preferably 20 mol% or more, even more preferably 30 mol% or more, and preferably 97 mol% or less, more preferably 90 mol% or less, even more preferably 85 mol% or less, based on 100 mol% of the total structural units.

The vinyl copolymer (B) may further have a structural unit (B-4) having an ultraviolet curable functional group. By further having the structural unit (B-4), the solvent resistance, heat resistance, and the like of the film can further be increased. Examples of the ultraviolet curable functional group include an ethylenic unsaturated bond, and the ultraviolet curable functional group is preferably an ethylenic unsaturated double bond. The ultraviolet curable functional group is preferably an ethylenic unsaturated bond such as a (meth)acryloyl group, a vinyl group, or an allyl group. The structural unit (B-4) preferably has the ultraviolet curable functional group in a side chain.

The vinyl copolymer (B) having the structural unit (B-4) can be produced by reacting, for example, a compound (b-4) having both an epoxy group and an ultraviolet curable functional group per molecule with the carboxy group(s) in the structural unit(s) (B-1) and/or (B-2) in the vinyl polymer having the structural units (B-1) to (B-3) in the copresence of a reaction catalyst and a polymerization inhibitor usually at about 80°C or more and 130°C or less to convert at least a part of the above structural unit(s) (B-1) and/or (B-2) to the structural unit (B-4). According to this method, the structural unit (B-4) in which an ultraviolet curable functional group is introduced into a side chain is formed by the reaction between the carboxy group and the epoxy group.

Examples of the compound (b-4) having both an epoxy group and an ultraviolet curable functional group per molecule include glycidyl (meth)acrylate, 4-glycidyloxybutyl (meth)acrylate, and 3,4-epoxycyclohexylmethyl (meth) acrylate.

Examples of the reaction catalyst include tertiary amine such as triethylamine, quaternary ammonium salts such as triethylbenzylammonium chloride, imidazole compounds such as 2-ethyl-4-methylimidazole, and phosphorus compounds such as triphenylphosphine.

Examples of the polymerization inhibitor include oxygen, and derivatives of methoquinone, hydroquinone, trimethylhydroquinone, N-nitrosophenylhydroxylamine, 2,2,6,6-tetramethylpiperidinyl-1-oxyl, and 2,2,6,6-tetramethylpiperidinyl-1-oxyl.

The vinyl copolymer (B) preferably has an ethylenic unsaturated bond equivalent which is the weight-average molecular weight per mole of ethylenic unsaturated bond of more than 1000, more preferably 2000 or more, even more preferably 3000 or more, and preferably 8000 or less, more preferably 6000 or less, even more preferably 4000 or less. The ethylenic unsaturated bond equivalent within the above-described range can be advantageous in further increasing the solvent resistance, heat resistance, and the like of the film. The ethylenic unsaturated bond equivalent of the vinyl copolymer (B) can be measured according to the method described in the section of Examples later.

The vinyl copolymer (B) may have a structural unit other than the structural units (B-1) to (B-4). However, from the viewpoint of improving the patterning characteristics, light-emitting characteristics, and the like of the film, the total content ratio of the structural units (B-1) to (B-4) is preferably 80 mol% or more, more preferably 90 mol% or more, even more preferably 95 mol% or more, and particularly preferably 100 mol%, based on 100 mol% of the total structural units.

The vinyl copolymer (B) contains a tellurium compound. The tellurium compound is usually a compound derived from a chain transfer agent used upon preparation of the vinyl copolymer (B), which will be described later. The content of the tellurium compound in the vinyl copolymer (B) is usually more than 0 ppm, preferably 10 ppm or more, more preferably 20 ppm or more, and usually 350 ppm or less, preferably 200 ppm or less, more preferably 100 ppm or less, in terms of metal tellurium. Here, ppm is in terms of mass. The content of the tellurium compound within the above-described range is advantageous in obtaining a film having favorable patterning characteristics and light-emitting characteristics, and especially advantageous in obtaining a film having favorable light-emitting characteristics. The content of the tellurium compound in the vinyl copolymer (B) can be measured according to the method described in the section of Examples later.

The molecular weight distribution of the vinyl copolymer (B) is 2.0 or less, preferably 1.9 or less, more preferably

1.8 or less, even more preferably 1.7 or less, still more preferably 1.6 or less, and particularly preferably 1.55 or less. As the value of the molecular weight distribution becomes smaller, a copolymer having a narrow molecular weight distribution and uniform molecular weight is obtained. When the value is 1.0, the width of the molecular weight distribution is narrowest. That is, the lower limit value of the molecular weight distribution is 1.0. The molecular weight distribution within the above-described range is advantageous in obtaining a film having favorable patterning characteristics and light-emitting characteristics, and can further be advantageous in increasing the dispersibility of the quantum dot (A), the solvent resistance and heat resistance of the film, and the pot life (stability with time) of the composition. For example, the vinyl copolymer (B) having a molecular weight distribution within the above-described range can suitably be produced by the method, which will be described later.

The molecular weight distribution is represented by Mw/Mn, when the weight-average molecular weight of the vinyl copolymer (B) is taken as Mw and the number-average molecular weight thereof is taken as Mn. The weight-average molecular weight (Mw) and number-average molecular weight (Mn) of the vinyl copolymer (B) can be measured according to the method described in the section of Examples later.

The weight-average molecular weight (Mw) of the vinyl copolymer (B) is, for example, 3000 or more and 20000 or less, and from the viewpoint of improving the patterning characteristics, light-emitting characteristics, and the like of the film, preferably 4500 or more, more preferably 6000 or more, and preferably 14000 or less, more preferably 9500 or less. The Mw of the vinyl copolymer (B) can be appropriately adjusted by combining the reaction conditions such as the selection of the raw material to be used, the charging method, the reaction temperature and the time.

The acid value of the vinyl copolymer (B) is 100 mgKOH/g or more and 150 mgKOH/g or less, preferably 105 mgKOH/g or more, more preferably 120 mgKOH/g or more, even more preferably 130 mgKOH/g or more, and preferably 145 mgKOH/g or less, more preferably 140 mgKOH/g or less. The acid value within the above-described range is advantageous in obtaining a film having favorable patterning characteristics and light-emitting characteristics, and especially advantageous in obtaining a film having favorable patterning characteristics.

The acid value of the vinyl copolymer (B) is a value measured as the amount of potassium hydroxide (mg) required for neutralizing 1 g of the vinyl copolymer (B), and can be measured according to the method described in the section of Examples later. The acid value of the vinyl copolymer (B) can be controlled, for example, by adjusting the content ratio of the structural unit (B-1) and/or the structural unit (B-2) in the vinyl copolymer (B).

The vinyl copolymer (B) may be a random copolymer or a block copolymer. From the viewpoint of obtaining a film having favorable patterning characteristics and light-emitting characteristics, and furthermore, from the viewpoint of increasing the dispersibility of the quantum dot (A), the solvent resistance and heat resistance of the film, and the pot life (stability with time) of the composition, the vinyl copolymer (B) is preferably a block copolymer.

Examples of the block copolymer include a block copolymer having an A block and a B block. When two or more kinds of structural units are contained in the block, the structural units may be contained in either state of random copolymerization or block copolymerization in the block. In one embodiment, the vinyl copolymer (B) is preferably a block copolymer that has no other blocks other than the A block and the B block. When the structural unit (B-1) and the structural unit (B-2) are arranged in different blocks, there is a tendency that the patterning characteristics and light-emitting characteristics of the film can be more increased, and furthermore, the dispersibility of the quantum dot (A), the solvent resistance and heat resistance of the film, and the pot life (stability with time) of the composition can be more increased.

From the above viewpoints, examples of the preferable block copolymer include a block copolymer in which the A block has the structural unit (B-1) and has no structural unit (B-2), and the B block has the structural unit (B-2) and has no structural unit (B-1). The structural unit (B-3) is preferably contained in both the A block and the B block. In addition, the A block and/or the B block may have the structural unit (B-4).

In the vinyl copolymer (B) having the A block having the structural units (B-1) and (B-3), and the B block having the structural units (B-2) and (B-3), the content ratio of the structural unit (B-1) in the A block (when the A block further has the structural unit (B-4), the total content ratio with the content ratio of the structural unit (B-4)) is preferably 5 mol% or more, more preferably 10 mol% or more, even more preferably 15 mol% or more, and preferably 60 mol% or less, more preferably 50 mol% or less, even more preferably 40 mol% or less, based on 100 mol% of the total structural units of the A block. The content ratio of the structural unit (B-2) in the B block (when the B block further has the structural unit (B-4), the total content ratio with the content ratio of the structural unit (B-4)) is preferably 10 mol% or more, more preferably 15 mol% or more, and preferably 80 mol% or less, more preferably 75 mol% or less, even more preferably 70 mol% or less, based on 100 mol% of the total structural units of the B block.

The proportion of the total structural units of the A block in the total structural units of the vinyl copolymer (B) is, for example, 30 mol% or more, preferably 40 mol% or more, more preferably 50 mol% or more, even more preferably 60 mol% or more, and for example, 90 mol% or less, preferably 85 mol% or less, more preferably 80 mol% or less.

The vinyl copolymer (B) can be, for example, produced by a radical polymerization method. Above all, since precise control of the molecular weight distribution is excellent and a polymer having a uniform composition is easily produced, a living radical polymerization method is preferable, and a living radical polymerization method using an organic tellurium compound as the chain transfer agent is more preferable. Examples of the living radical polymerization method

include the methods described in WO 2004/14848 A1, WO 2004/14962 A1, WO 2004/072126 A1, and WO 2004/096870 A1.

Examples of the above-described living radical polymerization method using an organic tellurium compound include the following methods (a) to (d).

(a) Monomers are polymerized by using an organic tellurium compound represented by the formula (T1).
(b) Monomers are polymerized by using a mixture of an organic tellurium compound represented by the formula (T1) and an azo-based polymerization initiator.
(c) Monomers are polymerized by using a mixture of an organic tellurium compound represented by the formula (T1) and an organic ditelluride compound represented by the formula (T2).
(d) Monomers are polymerized by using a mixture of an organic tellurium compound represented by the formula (T1), an azo-based polymerization initiator, and an organic ditelluride compound represented by the formula (T2).

$$Z^A\text{-Te-}CZ^BZ^CZ^D \qquad (T1)$$

$$Z^A\text{-Te-Te-}Z^A \qquad (T2)$$

In the formula (T1) and the formula (T2), $Z^A$ represents an alkyl group having 1 or more and 8 or less carbon atoms, an aryl group, or an aromatic heterocyclic group. $Z^B$ and $Z^C$ each independently represents a hydrogen atom or an alkyl group having 1 or more and 8 or less carbon atoms. $Z^D$ represents an alkyl group having 1 or more and 8 or less carbon atoms, an aryl group, a substituted aryl group, an aromatic heterocyclic group, an alkoxy group, an acyl group, an amide group, an oxycarbonyl group, a cyano group, an allyl group, or a propargyl group.

Examples of the organic tellurium compound represented by the formula (T1) include organic tellurium compounds described in WO 2004/14848 A1, WO 2004/14962 A1, WO 2004/072126 A1, and WO 2004/096870 A1 such as ethyl=2-methyl-2-n-butyltellanyl-propionate, ethyl=2-n-butyltellanyl-propionate, and (2-hydroxyethyl)-2-methyl-methyltellanyl-propionate.

Examples of the organic ditelluride compound represented by the formula (T2) include dimethyl ditelluride and dibutyl ditelluride.

The azo-based polymerization initiator can be used without particular limitation, as long as it is an azo-based polymerization initiator usually used in radical polymerization, and examples thereof include 2,2'-azobis(isobutyronitrile) (AIBN), 2,2'-azobis(2,4-dimethylvaleronitrile) (ADVN), 1,1'-azobis(1-cyclohexane carbonitrile) (ACHN), and 2,2'-azobis(4-methoxy-2,4-dimethylvaleronitrile) (V-70).

The polymerization reaction of the living radical polymerization can be carried out by mixing the monomers, the organic tellurium compound of the formula (T1), and further, the azo-based polymerization initiator and/or the organic ditelluride compound of the formula (T2) to promote the reaction and control the molecular weight and the molecular weight distribution according to the kind of monomer and the like, in a container purged with an inert gas, and heating the mixture as necessary. Examples of the inert gas include nitrogen, argon, and helium, and the inert gas is preferably argon or nitrogen. The amount of the monomers used in the above-described methods (a), (b), (c), and (d) is only required to be appropriately regulated depending on the physical properties of the desired vinyl copolymer (B).

The polymerization reaction of the living radical polymerization can be carried out without a solvent, and may be carried out by stirring the above-described mixture using an aprotic solvent or a protic solvent generally used in radical polymerization. Examples of the aprotic solvent include anisole, benzene, toluene, propylene glycol monomethyl ether acetate, ethyl acetate, and tetrahydrofuran (THF). Examples of the protic solvent include water, methanol, and 1-methoxy-2-propanol. The solvent may be used singly or in combinations of two or more. The amount of the solvent used is only required to be appropriately regulated, and is preferably, for example, 0.01 mL or more and 50 mL or less based on 1 g of the monomer. The reaction temperature and the reaction time are only required to be appropriately regulated depending on the molecular weight or molecular weight distribution of the vinyl copolymer (B) to be obtained, and usually, stirring is carried out at 0°C or more and 150°C or less for 1 minute or more and 100 hours or less.

After termination of the polymerization reaction, for example, the solvent used and remaining monomers are removed from the resulting reaction mixture by usual separation and purification means, so that the desired vinyl copolymer (B) can be separated.

The growth terminal of the vinyl copolymer (B) obtained by the polymerization reaction is in the form of $-TeZ^A$ (wherein $Z^A$ is the same as above), and the tellurium atom is removed from the growth terminal by the separation and purification means after termination of the polymerization reaction. In general, the tellurium compound derived from the chain transfer agent may remain in the vinyl copolymer (B) also after removal of the tellurium atom.

The above-described vinyl copolymer (B) having the structural unit (B-4) can be obtained by producing a vinyl polymer having the structural units (B-1) to (B-3), and then carrying out the reaction using the compound (b-4) having both

an epoxy group and an ultraviolet curable functional group per molecule as described above.

The content ratio of the vinyl copolymer (B) in the composition is, for example, 5% by mass or more, preferably 10% by mass or more, more preferably 15% by mass or more, even more preferably 20% by mass or more, and for example, 80% by mass or less, preferably 70% by mass or less, more preferably 60% by mass or less, even more preferably 55% by mass or less, based on the total amount of the solids content of the composition. When the content ratio of the vinyl copolymer (B) is within the above-described range, the dispersibility of the quantum dot (A), the solvent resistance and heat resistance of the film, and the pot life (stability with time) of the composition tend to be easily improved. In addition, the patterning characteristics and light-emitting characteristics of the film tend to be easily improved accordingly, and furthermore, the dispersibility of the quantum dot (A), the solvent resistance and heat resistance of the film, and the pot life (stability with time) of the composition tend to be easily improved.

In the composition, the mass ratio (solids content ratio) of the vinyl copolymer (B) to the polymerizable compound (C), which will be described later, is for example, 1 or more, and from the viewpoint of the patterning characteristics and light-emitting characteristics of the film, preferably 1.5 or more, and more preferably 2 or more.

[4] Polymerizable compound (C)

The composition may further contain a polymerizable compound (C). The polymerizable compound (C) is a compound that is polymerizable due to, for example, an active radial or an acid generated from the polymerization initiator (D), which will be described later. Examples of the polymerizable compound (C) include a photopolymerizable compound such as a compound having an ethylenic unsaturated bond, such as a (meth)acrylic acid ester compound. Other examples of the polymerizable compound (C) include a thermally polymerizable compound. The composition may contain two or more kinds of the polymerizable compounds (C).

The polymerizable compound (C) is preferably a photopolymerizable compound having three or more ethylenic unsaturated bonds per molecule. The weight-average molecular weight of the polymerizable compound (C) is preferably 150 or more, more preferably 250 or more, and preferably 2900 or less, more preferably 1500 or less.

Examples of the photopolymerizable compound having three or more ethylenic unsaturated bonds per molecule include a compound having three or more ethylenic unsaturated bonds per molecule and having an acid functional group, (Ca); and a compound having three or more ethylenic unsaturated bonds per molecule and having no acid functional group, (Cb). The polymerizable compound (C) preferably contains at least one of the compound (Ca) and the compound (Cb), or may contain two or more kinds of the compounds (Ca), two or more kinds of the compounds (Cb), or at least one compound (Ca) and at least one compound (Cb).

Examples of the acid functional group include a carboxy group, a sulfonic acid group, and a phosphoric acid group. The acid functional group is preferably a carboxy group among these.

When the polymerizable compound (C) contains the compound (Ca), the dispersibility of the quantum dot (A) in the composition can be improved, and the light-emitting characteristics of the film may be improved. When the polymerizable compound (C) contains the compound (Ca), the curability and heat resistance of the composition may be improved.

The ethylenic unsaturated bond in the compound (Ca) is preferably a (meth)acryloyloxy group. The number of the ethylenic unsaturated bond per molecule of the compound (Ca) is preferably 3 or more and 5 or less, more preferably 3. The number of the acid functional group compound (Ca) per molecule of the compound (Ca) is 1 or more. In a case where the compound (Ca) has two or more acid functional groups, the acid functional groups may be different or the same, and the compound (Ca) preferably has at least one carboxy group.

Examples of the compound (Ca) include a compound obtained by modifying a compound having three or more (meth)acryloyloxy groups and a hydroxy group such as pentaerythritol tri(meth)acrylate or dipentaerythritol penta(meth) acrylate to polybasic acid. Examples of the compound include a monoester compound of pentaerythritol tri(meth)acrylate and dibasic acid (for example, succinic acid or maleic acid) or an acid anhydride thereof, and a monoester compound of dipentaerythritol penta(meth)acrylate and dibasic acid (for example, succinic acid or maleic acid) or an acid anhydride thereof.

The ethylenic unsaturated bond in the compound (Cb) is preferably a (meth)acryloyloxy group. The number of the ethylenic unsaturated bond per molecule of the compound (Cb) is preferably 3 or more and 6 or less.

Examples of the compound (Cb) include trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, tripentaerythritol octa(meth)acrylate, tripentaerythritol hepta(meth)acrylate, tetrapentaerythritol deca(meth)acrylate, tetrapentaerythritol nona(meth)acrylate, tris(2-(meth)acryloyloxyethyl)isocyanurate, ethylene glycol-modified pentaerythritol tetra(meth)acrylate, ethylene glycol-modified dipentaerythritol hexa(meth)acrylate, propylene glycol-modified pentaerythritol tetra(meth)acrylate, propylene glycol-modified dipentaerythritol hexa(meth)acrylate, caprolactone modified pentaerythritol tetra(meth)acrylate, and caprolactone modified dipentaerythritol hexa(meth)acrylate. Among these, dipentaerythritol penta(meth)acrylate, dipentaerythritol hexa(meth)acrylate, or the like is preferable.

When the composition contains the polymerizable compound (C), the content ratio of the polymerizable compound (C) in the composition is preferably 5% by mass or more, more preferably 7% by mass or more, even more preferably 10% by mass or more, and preferably 60% by mass or less, more preferably 45% by mass or less, even more preferably 30% by mass or less, based on the total amount of the solids content of the composition. When the content ratio of the polymerizable compound (C) is within the above-described range, the developability of the composition and the solvent resistance of the film tend to be improved.

[5] Polymerization initiator (D)

The composition may further contain a polymerization initiator (D). The polymerization initiator (D) is a compound that may generate, for example, an active radical or an acids by action of light or heat to initiate polymerization of the polymerizable compound (C). The composition can contain one or two or more kinds of the polymerization initiators (D).

Examples of the polymerization initiator (D) include a photopolymerization initiator, such as an oxime compound, an alkylphenone compound, a bimidazole compound, a triazine compound, and an acylphosphine compound, and a thermal polymerization initiator, such as an azo compound and an organic peroxide.

An example of the oxime compound is an oxime compound having the first molecular structure represented by the formula (1) below. This oxime compound will be hereinafter also referred to as "oxime compound (1)".

[Formula 11]

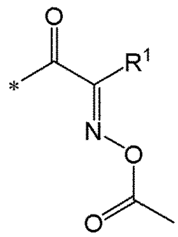

(1)

Including the oxime compound (1) as the polymerization initiator (D) is advantageous in terms of view of improving the light-emitting characteristics of the film. One reason for exhibiting such an effect is inferred as follows: due to the characteristic molecular structure of the oxime compound (1), the absorption wavelength of the oxime compound (1) significantly changes before and after cleavage (decomposition), which is necessary to initiate photopolymerization by the oxime compound (1), and the oxime compound (1) thus has the large capability of initiating radical photopolymerization.

In the formula (1), $R^1$ represents $R^{11}$, $OR^{11}$, $COR^{11}$, $SR^{11}$, $CONR^{12}R^{13}$, or CN.

$R^{11}$, $R^{12}$, and $R^{13}$ each independently represent a hydrogen atom, an alkyl group having 1 or more and 20 or less carbon atoms, an aryl group having 6 or more and 30 or less carbon atoms, an aralkyl group having 7 or more and 30 or less carbon atoms, or a heterocyclic group having 2 or more and 20 or less carbon atoms.

A hydrogen atom of the group represented by $R^{11}$, $R^{12}$, or $R^{13}$ is optionally replaced by $OR^{21}$, $COR^{21}$, $SR^{21}$, $NR^{22}R^{23}$, $CONR^{22}R^{23}$, $-NR^{22}-OR^{23}$, $-N(COR^{22})-OCOR^{23}$, $-C(=N-OR^{21})-R^{22}$, $-C(=N-OCOR^{21})-R^{22}$, CN, a halogen atom, or $COOR^{21}$.

$R^{21}$, $R^{22}$, and $R^{23}$ each independently represent a hydrogen atom, an alkyl group having 1 or more and 20 or less carbon atoms, an aryl group having 6 or more and 30 or less carbon atoms, an aralkyl group having 7 or more and 30 or less carbon atoms, or a heterocyclic group having 2 or more and 20 or less carbon atoms.

A hydrogen atom of the group represented by $R^{21}$, $R^{22}$, or $R^{23}$ is optionally replaced by CN, a halogen atom, a hydroxy group, or a carboxy group.

In a case where the group represented by $R^{11}$, $R^{12}$, $R^{13}$, $R^{21}$, $R^{22}$, or $R^{23}$ has an alkylene moiety, the alkylene moiety may be interrupted 1 or more and 5 or less times by -O-, -S-, -COO-, -OCO-, $-NR^{24}-$, $-NR^{24}CO-$, $-NR^{24}COO-$ , $-OCONR^{24}-$, -SCO-, - COS-, -OCS-, or -CSO-.

$R^{24}$ represents a hydrogen atom, an alkyl group having 1 or more and 20 or less carbon atoms, an aryl group having 6 or more and 30 or less carbon atoms, an aralkyl group having 7 or more and 30 or less carbon atoms, or a heterocyclic group having 2 or more and 20 or less carbon atoms.

In a case where the group represented by $R^{11}$, $R^{12}$, $R^{13}$, $R^{21}$, $R^{22}$, or $R^{23}$ has an alkyl moiety, the alkyl moiety may be branched or cyclic, and $R^{12}$ and $R^{13}$, or $R^{22}$ and $R^{23}$ may together form a ring.

**[0147]** * represent a bond to the second molecular structure, which is another molecular structure different from the first molecular structure of the oxime compound (1).

Examples of the alkyl group having 1 or more and 20 or less carbon atoms represented by $R^{11}$, $R^{12}$, $R^{13}$, $R^{21}$, $R^{22}$, $R^{23}$, and $R^{24}$ in the formula (1) include a methyl group, an ethyl group, a propyl group, an isopropyl group, a butyl group, an isobutyl group, a sec-butyl group, a tert-butyl group, a pentyl group, an isopentyl group, a tert-pentyl group, a hexyl group, a

heptyl group, an octyl group, an isooctyl group, a 2-ethylhexyl group, a tert-octyl group, a nonyl group, an isononyl group, a decyl group, an isodecyl group, an undecyl group, a dodecyl group, a tetradecyl group, a hexadecyl group, an octadecyl group, an icosyl group, a cyclopentyl group, a cyclohexyl group, a cyclohexylmethyl group, and a cyclohexylethyl group.

Examples of the aryl group having 6 or more and 30 or less carbon atoms represented by $R^{11}$, $R^{12}$, $R^{13}$, $R^{21}$, $R^{22}$, $R^{23}$, and $R^{24}$ in the formula (1) include a phenyl group, a tolyl group, a xylyl group, an ethylphenyl group, a naphthyl group, an anthryl group, a phenanthryl group, and a phenyl group, a biphenyl group, a naphthyl group, and an anthryl group substituted with one or more aforementioned alkyl groups.

Examples of the aralkyl group having 7 or more and 30 or less carbon atoms represented by $R^{11}$, $R^{12}$, $R^{13}$, $R^{21}$, $R^{22}$, $R^{23}$, and $R^{24}$ in the formula (1) include a benzyl group, an $\alpha$-methylbenzyl group, an $\alpha$, $\alpha$-dimethylbenzyl group, and a phenylethyl group.

Examples of the heterocyclic group having 2 or more and 20 or less carbon atoms represented by $R^{11}$, $R^{12}$, $R^{13}$, $R^{21}$, $R^{22}$, $R^{23}$, and $R^{24}$ in the formula (1) include a pyridyl group, a pyrimidyl group, a furyl group, a thienyl group, a tetrahydrofuryl group, a dioxolanyl group, a benzoxazol-2-yl group, a tetrahydropyranyl group, a pyrrolidyl group, an imidazolidyl group, a pyrazolidyl group, a thiazolidyl group, an isothiazolidyl group, an oxazolidyl group, an isoxazolidyl group, a piperidyl group, a piperazyl group, and a morpholinyl group, and the heterocyclic group is preferably a 5-to 7-membered heterocyclic ring.

For the formula (1), the phrase "$R^{12}$ and $R^{13}$, or $R^{22}$ and $R^{23}$ may together form a ring" means that $R^{12}$ and $R^{13}$, or $R^{22}$ and $R^{23}$, together with the nitrogen atom, carbon atom, or oxygen atom connected thereto, may form a ring.

Examples of the ring that may be formed by $R^{12}$ and $R^{13}$, or $R^{22}$ and $R^{23}$, together in the formula (1) include a cyclopentane ring, a cyclohexane ring, a cyclopentene ring, a benzene ring, a piperidine ring, a morpholine ring, a lactone ring, and a lactam ring, and the ring is preferably a 5- to 7-membered ring.

Example of the halogen atom which $R^{11}$, $R^{12}$, $R^{13}$, $R^{21}$, $R^{22}$, and $R^{23}$ in the formula (1) optionally has as a substituent include a fluorine atom, a chlorine atom, a bromine atom, and an iodine atom.

$R^1$ in the formula (1) is preferably $R^{11}$, more preferably an alkyl group having 1 or more and 20 or less carbon atoms, even more preferably an alkyl group having 1 or more and 10 or less carbon atoms, and still more preferably an alkyl group having 1 or more and 6 or less carbon atoms.

One example of the second molecular structure linked to the first molecular structure represented by the formula (1) is the structure represented by the formula (2). The second molecular structure is the molecular structure moiety other than the first molecular structure in the oxime compound (1).

The bond represented by "*" in the formula (2) is directly bonded to the bond represented by "*" in the formula (1). In other words, when the second molecular structure is the structure represented by the formula (2), the benzene ring having "-*" in the formula (2) is directly bonded to the carbonyl group having "-*" in the formula (1).

[Formula 12]

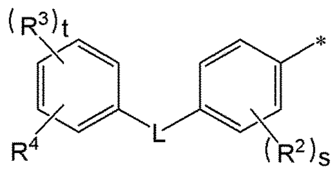

(2)

In the formula (2), $R^2$ and $R^3$ each independently represent $R^{11}$, $OR^{11}$, $SR^{11}$, $COR^{11}$, $CONR^{12}R^{13}$, $NR^{12}COR^{11}$, $OCOR^{11}$, $COOR^{11}$, $SCOR^{11}$, $OCSR^{11}$, $COSR^{11}$, $CSOR^{11}$, CN, or a halogen atom.

When a plurality of $R^2$ are present, they may be the same or different.

When a plurality of $R^3$ are present, they may be the same or different.

$R^{11}$, $R^{12}$, and $R^{13}$ each have the same meaning as above described.

s and t each independently represent an integer of 0 or more and 4 or less.

L represents a sulfur atom, $CR^{31}R^{32}$, CO, or $NR^{33}$.

$R^{31}$, $R^{32}$, and $R^{33}$ each independently represent a hydrogen atom, an alkyl group having 1 or more and 20 or less carbon atoms, an aryl group having 6 or more and 30 or less carbon atoms, or an aralkyl group having 7 or more and 30 or less carbon atoms.

When the group represented by $R^{31}$, $R^{32}$, or $R^{33}$ has an alkyl moiety, the alkyl moiety may be branched or cyclic, and $R^{31}$, $R^{32}$, and $R^{33}$ may each independently, together with either adjacent benzene ring, form a ring.

$R^4$ represents a hydroxy group, a carboxy group, or a group represented by the following formula (2-1):
[Formula 13]

$(R^{4a})_v$-$L^2$-$L^1$- (2-1)

(in the formula (2-1), $L^1$ represents -O-, -S-, $-NR^{22}-$, $-NR^{22}CO-$, $-SO_2-$, -CS-, -OCO-, or -COO-,

$R^{22}$ has the same meaning as above described,
$L^2$ represents a group formed by removing a number v of hydrogen atoms from an alkyl group having 1 or more and 20 or less carbon atoms, a group formed by removing a number v of hydrogen atoms from an aryl group having 6 or more and 30 or less carbon atoms, a group formed by removing a number v of hydrogen atoms from an aralkyl group having 7 or more and 30 or less carbon atoms, or a group formed by removing a number v of hydrogen atoms from a heterocyclic group having 2 or more and 20 or less carbon atoms,
when the group represented by $L^2$ has an alkylene moiety, the alkylene moiety may be interrupted 1 or more and 5 or less times by -O-, -S-, -COO-, -OCO-, $-NR^{22}-$, $-NR^{22}COO-$, $-OCONR^{22}-$, -SCO-, -COS-, -OCS-, or -CSO-, and the alkylene moiety may be branched or cyclic,
$R^{4a}$ represents $OR^{41}$, $SR^{41}$, $CONR^{42}R^{43}$, $NR^{42}COR^{43}$, $OCOR^{41}$, $COOR^{41}$, $SCOR^{41}$, $OCSR^{41}$, $COSR^{41}$, $CSOR^{41}$, CN, or a halogen atom,
when a plurality of $R^{4a}$ are present, they may be the same or different,
$R^{41}$, $R^{42}$, and $R^{43}$ each independently represent a hydrogen atom, an alkyl group having 1 or more and 20 or less carbon atoms, an aryl group having 6 or more and 30 or less carbon atoms, or an aralkyl group having 7 or more and 30 or less carbon atoms; when the group represented by $R^{41}$, $R^{42}$, or $R^{43}$ has an alkyl moiety, the alkyl moiety may be branched or cyclic, and $R^{42}$ and $R^{43}$ may together form a ring, and
v represents an integer of 1 or more and 3 or less).
* represents a bond to the first molecular structure of the oxime compound (1).

For the alkyl group having 1 or more and 20 or less carbon atoms, the aryl group having 6 or more and 30 or less carbon atoms, or the aralkyl group having 7 or more and 30 or less carbon atoms represented by $R^{11}$, $R^{12}$, $R^{13}$, $R^{21}$, $R^{22}$, $R^{23}$, $R^{24}$, $R^{31}$, $R^{32}$ and $R^{33}$ in the formula (2), and $R^{22}$, $R^{41}$, $R^{42}$, and $R^{43}$ in the formula (2-1), examples thereof include those listed for $R^{11}$, $R^{12}$, $R^{13}$, $R^{21}$, $R^{22}$, $R^{23}$, and $R^{24}$ in the formula (1).
For the heterocyclic group having 2 or more and 20 or less carbon atoms represented by $R^{11}$, $R^{12}$, $R^{13}$, $R^{21}$, $R^{22}$, $R^{23}$, and $R^{24}$ in the formula (2), and $R^{22}$ in the formula (2-1), examples thereof include those listed for $R^{11}$, $R^{12}$, $R^{13}$, $R^{21}$, $R^{22}$, $R^{23}$, and $R^{24}$ in the formula (1).
For the formula (2), the phrase "$R^{31}$, $R^{32}$, and $R^{33}$ may each independently, together with either adjacent benzene ring, form a ring" means $R^{31}$, $R^{32}$, and $R^{33}$ each independently, together with either adjacent benzene ring and also with the nitrogen atom connected thereto, may form a ring.
Examples of the ring that may be formed by $R^{31}$, $R^{32}$, or $R^{33}$ together with either adjacent benzene ring in the formula (2) include those listed for the ring that may be formed by $R^{12}$ and $R^{13}$, or $R^{22}$ and $R^{23}$, together in the formula (1).
$L^2$ in the formula (2-1) represents a group formed by removing a number v of hydrogen atoms from an alkyl group having 1 or more and 20 or less carbon atoms, an aryl group having 6 or more and 30 or less carbon atoms, an aralkyl group having 7 or more and 30 or less carbon atoms, or a heterocyclic group having 2 or more and 20 or less carbon atoms.
Examples of the group formed by removing a number v of hydrogen atoms from an alkyl group having 1 or more and 20 or less carbon atoms when v is 1 include alkylene groups such as a methylene group, an ethylene group, a propylene group, a methylethylene group, a butylene group, a 1-methylpropylene group, a 2-methylpropylene group, a 1,2-dimethylpropylene group, a 1,3-dimethylpropylene group, a 1-methylbutylene group, a 2-methylbutylene group, a 3-methylbutylene group, a 4-methylbutylene group, a 2,4-dimethylbutylene group, a 1,3-dimethylbutylene group, a pentylene group, a hexylene group, a heptylene group, an octylene group, a nonylene group, a decylene group, a dodecylene group, a tridecylene group, a tetradecylene group, a pentadecylene group, an ethane-1,1-diyl group, and a propane-2,2-diyl group.
Examples of the group formed by removing a number v of hydrogen atoms from an aryl group having 6 or more and 30 or less carbon atoms when v is 1 include arylene groups such as a 1,2-phenylene group, a 1,3-phenylene group, a 1,4-phenylene group, a 2,6-naphthylene group, a 1,4-naphthylene group, a 2,5-dimethyl-1,4-phenylene group, an diphenylmethane-4,4'-diyl group, a 2,2-diphenylpropane-4,4'-diyl group, a diphenylsulfide-4,4'-diyl group, and diphenylsulfone-4,4'-diyl group.
Examples of the group formed by removing a number v of hydrogen atoms from an aralkyl group having 7 or more and 30 or less carbon atoms when v is 1 include a group represented by the following formula (a) and a group represented by the following formula (b).

[Formula 14]

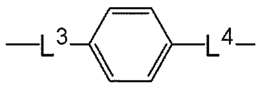 (a) 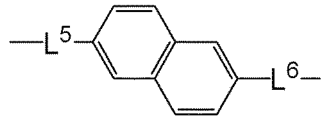 (b)

[in the formulae (a) and (b), $L^3$ and $L^5$ represent an alkylene group having 1 or more and 10 or less carbon atoms, and $L^4$ and $L^6$ represent a single bond or an alkylene group with 1 or more and 10 or less carbon atoms.]

Examples of the alkylene group having 1 or more and 10 or less carbon atoms include a methylene group, an ethylene group, a propylene group, a methylethylene group, a butylene group, a 1-methylpropylene group, a 2-methylpropylene group, a 1,2-dimethylpropylene group, a 1,3-dimethylpropylene group, a 1-methylbutylene group, a 2-methylbutylene group, a 3-methylbutylene group, a 4-methylbutylene group, a 2,4-dimethylbutylene group, a 1,3-dimethylbutylene group, a pentylene group, a hexylene group, a heptylene group, an octylene group, a nonylene group, and a decylene group.

Examples of the group formed by removing a number v of hydrogen atoms from a heterocyclic group having 2 or more and 20 or less carbon atoms when v is 1 include divalent heterocyclic groups such as a 2,5-pyridinediyl group, a 2,6-pyridinediyl group, a 2,5-pyrimidinediyl group, a 2,5-thiophenediyl group, a 3,4-tetrahydrofurandiyl group, a 2,5-tetrahydrofurandiyl group, a 2,5-furandiyl group, a 3,4-thiazolidiyl group, a 2,5-benzofuranediyl group, a 2,5-benzothiophenediyl group, an N-methylindole-2,5-diyl group, a 2,5-benzothiazoldiyl group, and a 2,5-benzoxazoldiyl group.

Examples of the halogen atom represented by $R^2$ or $R^3$ in the formula (2) and $R^{4a}$ in the formula (2-1) include a fluorine atom, a chlorine atom, a bromine atom, and an iodine atom.

A preferable example of the structure represented by the formula (2) is a structure represented by the formula (2a) below, in view of solubility in a solvent (E) and/or developability of the composition.

[Formula 15]

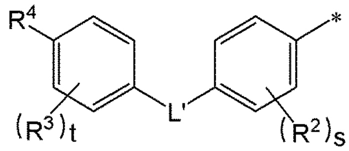 (2a)

[in the formula (2a), L' represents a sulfur atom or $NR^{50}$, and $R^{50}$ represents a linear, branched, or cyclic alkyl group having 1 or more and 20 or less carbon atoms, and $R^2$, $R^3$, $R^4$, s, and t have the same meaning as described above.]

From the same viewpoint, another preferable example of the structure represented by the formula (2) is a structure represented by the following formula (2b):

[Formula 16]

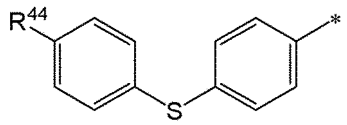 (2b)

[in the formula (2b), $R^{44}$ represents a hydroxy group, a carboxy group, or a group represented by the following formula (2-2):

[Formula 17]

$R^{44a}$-$L^{12}$-$L^{11}$- (2-2)

(in the formula (2-2), $L^{11}$ represents -O- or *-OCO-, * represents the bond to $L^{12}$, $L^{12}$ represents an alkylene group having 1 or more and 20 or less carbon atoms, the alkylene group may be interrupted 1 or more and 3 or less times by -O-, $R^{44a}$ represents $OR^{55}$ or $COOR^{55}$, and $R^{55}$ represents a hydrogen atom or an alkyl group having 1 or more and 6 or less carbon atoms.)].

$R^{44}$ is preferably a group represented by the formula (2-2). This is advantageous in terms of solubility of the oxime compound (1) in a solvent (E) and developability of the composition.

The alkylene group represented by $L^{12}$ preferably has 1 or more and 10 or less carbon atoms, more preferably 1 or more and 4 or less carbon atoms.

$R^{44a}$ is preferably a hydroxy group or a carboxy group, more preferably a hydroxy group.

The method for producing the oxime compound (1) having the second molecular structure represented by the formula (2) is not particularly limited, and such an oxime compound can be produced by a method described in JP 2011-132215 A, for example.

Another example of the second molecular structure linked to the first molecular structure represented by the formula (1) is a structure represented by the formula (3) below.

The bond represented by "*" in the formula (3) is directly bonded to the bond represented by "*" in the formula (1). In other words, when the second molecular structure is the structure represented by the formula (3), the benzene ring having "-*" in the formula (3) is directly bonded to the carbonyl group having "-*" in the formula (1).

[0162] [Formula 18]

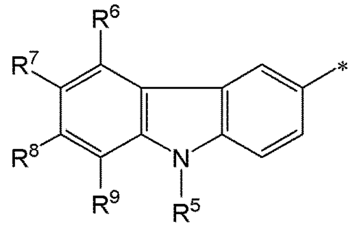

(3)

In the formula (3), $R^5$ represents a hydrogen atom, an alkyl group having 1 or more and 20 or less carbon atoms, an aryl group having 6 or more and 30 or less carbon atoms, an arylalkyl group having 7 or more and 30 or less carbon atoms, or a heterocyclic group having 2 or more and 20 or less carbon atoms.

When the group represented by $R^5$ has an alkyl moiety, the alkyl moiety may be branched or cyclic.

A hydrogen atom of the group represented by $R^5$ is optionally replaced by $R^{21}$, $OR^{21}$, $COR^{21}$, $SR^{21}$, $NR^{22}R^{23}$, $CONR^{22}R^{23}$, $-NR^{22}-OR^{23}$, $-N(COR^{22})-OCOR^{23}$, $NR^{22}COR^{21}$, $OCOR^{21}$, $COOR^{21}$, $-C(=N-OR^{21})-R^{22}$, $-C(=N-OCOR^{21})-R^{22}$, $SCOR^{21}$, $OCSR^{21}$, $COSR^{21}$, $CSOR^{21}$, a hydroxy group, a nitro group, CN, a halogen atom, or $COOR^{21}$.

$R^{21}$, $R^{22}$, and $R^{23}$ have the same meaning as described above.

A hydrogen atom of the group represented by $R^{21}$, $R^{22}$, or $R^{23}$ is optionally replaced by CN, a halogen atom, a hydroxy group, or a carboxy group.

When the group represented by $R^{21}$, $R^{22}$, or $R^{23}$ has an alkylene moiety, the alkylene moiety may be interrupted 1 or more and 5 or less times by -O-, -S-, -COO-, - OCO-, $-NR^{24}-$, $-NR^{24}CO-$, $-NR^{24}COO-$, $-OCONR^{24}-$, -SCO-, -COS-, -OCS-, or -CSO-.

$R^{24}$ has the same meaning as described above.

When the group represented by $R^{21}$, $R^{22}$, or $R^{23}$ has an alkyl moiety, the alkyl moiety may be branched or cyclic, and $R^{22}$ and $R^{23}$ may together form a ring.

$R^6$, $R^7$, $R^8$, and $R^9$ each independently represent $R^{61}$, $OR^{61}$, $SR^{61}$, $COR^{62}$, $CONR^{63}R^{64}$, $NR^{65}COR^{61}$, $OCOR^{61}$, $COOR^{62}$, $SCOR^{61}$, $OCSR^{61}$, $COSR^{62}$, $CSOR^{61}$, a hydroxy group, a nitro group, CN, or a halogen atom.

$R^{61}$, $R^{62}$, $R^{63}$, $R^{64}$, and $R^{65}$ each independently represent a hydrogen atom, an alkyl group having 1 or more and 20 or less carbon atoms, an aryl group having 6 or more and 30 or less carbon atoms, an arylalkyl group having 7 or more and 30 or less carbon atoms, or a heterocyclic group having 2 or more and 20 or less carbon atoms.

A hydrogen atom of the group represented by $R^{61}$, $R^{62}$, $R^{63}$, $R^{64}$, or $R^{65}$ is optionally replaced by $OR^{21}$, $COR^{21}$, $SR^{21}$, $NR^{22}R^{23}$, $CONR^{22}R^{23}$, $-NR^{22}-OR^{23}$, $-N(COR^{22})-OCOR^{23}$, $-C(=N-OR^{21})-R^{22}$, $-C(=N-OCOR^{21})-R^{22}$, CN, a halogen atom, or $COOR^{21}$.

$R^6$ and $R^7$; $R^7$ and $R^8$; and $R^8$ and $R^9$ each may together form a ring.

**[0198]** * represents a bond to the first molecular structure of the oxime compound (1).

For the alkyl group having 1 or more and 20 or less carbon atoms, the aryl group having 6 or more and 30 or less carbon atoms, the aralkyl group having 7 or more and 30 or less carbon atoms, and the heterocyclic group having 2 or more and 20 or less carbon atoms represented by $R^5$, $R^{21}$, $R^{22}$, $R^{23}$, $R^{24}$, $R^{61}$, $R^{62}$, $R^{63}$, $R^{64}$ or $R^{65}$ in the formula (3), examples thereof include those listed for $R^{11}$, $R^{12}$, $R^{13}$, $R^{21}$, $R^{22}$, $R^{23}$, and $R^{24}$ in the formula (1).

For the formula (3), the phrase "$R^{22}$ and $R^{23}$ may together form a ring" means that $R^{22}$ and $R^{23}$, together with the nitrogen atom, the carbon atom, or the oxygen atom connected thereto, may form a ring.

Examples of the ring that may be formed by $R^{22}$ and $R^{23}$ together in the formula (3) include those listed for the ring that may be formed by $R^{12}$ and $R^{13}$, or $R^{22}$ and $R^{23}$ together in the formula (1).

Examples of the halogen atom represented by $R^6$, $R^7$, $R^8$, or $R^9$ and the halogen atom that may replace a hydrogen atom of $R^5$, $R^{21}$, $R^{22}$, $R^{23}$, $R^{61}$, $R^{62}$, $R^{63}$, $R^{64}$, or $R^{65}$ in the formula (3) include a fluorine atom, a chlorine atom, a bromine atom, and an iodine atom.

In a preferable embodiment, $R^5$ is a group represented by the formula (3-1) in view of solubility in a solvent (E)

and/or developability of the composition.

[Formula 19]

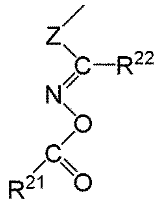

(3-1)

[in the formula (3-1), Z represents a group formed by removing one hydrogen atom from an alkyl group having 1 or more and 20 or less carbon atoms, a group formed by removing one hydrogen atom from an aryl group having 6 or more and 30 or less carbon atoms, a group formed by removing one hydrogen atom from an aralkyl group having 7 or more and 30 or less carbon atoms, or a group formed by removing one hydrogen atom from a heterocyclic group having 2 or more and 20 or less carbon atoms,

when the group represented by Z has an alkylene moiety, the alkylene moiety may be interrupted 1 or more and 5 or less times by -O-, -S-, -COO-, -OCO-, $-NR^{24}-$, - $NR^{24}COO-$, $-OCONR^{24}-$, -SCO-, -COS-, -OCS-, or -CSO-, and the alkylene moiety may be branched or cyclic, and

$R^{21}$, $R^{22}$, and $R^{24}$ have the same meaning as described above.]

From the same viewpoint, Z in the formula (3-1) is preferably a methylene group, an ethylene group, or a phenylene group.

From the same viewpoint, $R^{21}$ and $R^{22}$ in the formula (3-1) is preferably an alkyl group having 1 or more and 20 or less carbon atoms or an aryl group having 6 or more and 30 or less carbon atoms, and more preferably a methyl group, an ethyl group, or a phenyl group.

In another preferable embodiment, $R^7$ is a nitro group from the same viewpoint.

The method for producing the oxime compound (1) having the second molecular structure represented by the formula (3) is not particularly limited, and such an oxime compound can be produced by a method described in JP 2000-80068 A or JP 2011-178776 A, for example.

Still another example of the second molecular structure linked to the first molecular structure represented by the formula (1) is a structure represented by the formula (4) below.

The bond represented by "*" in the formula (4) is directly bonded to the bond represented by "*" in the formula (1). In other words, when the second molecular structure is the structure represented by the formula (4), the benzene ring having "-*" in the formula (4) is directly bonded to the carbonyl group having "-*" in the formula (1).

[Formula 20]

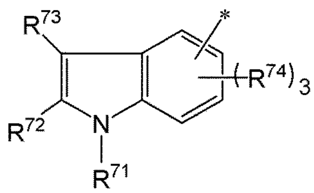

(4)

In the formula (4), $R^{71}$ represents a hydrogen atom, an alkyl group having 1 or more and 20 or less carbon atoms, an aryl group having 6 or more and 30 or less carbon atoms, an aralkyl group having 7 or more and 30 or less carbon atoms, or a heterocyclic group having 2 or more and 20 or less carbon atoms.

When the group represented by $R^{71}$ has an alkyl moiety, the alkyl moiety may be branched or may be cyclic.

A hydrogen atom of the group represented by $R^{71}$ is optionally replaced by $R^{21}$, $OR^{21}$, $COR^{21}$, $SR^{21}$, $NR^{22}R^{23}$, $CONR^{22}R^{23}$, $-NR^{22}-OR^{23}$, $-N(COR^{22})-OCOR^{23}$, $NR^{22}COR^{21}$, $OCOR^{21}$, $COOR^{21}$, $-C(=N-OR^{21})-R^{22}$, $-C(=N-OCOR^{21})-R^{22}$, $SCOR^{21}$, $OCSR^{21}$, $COSR^{21}$, $CSOR^{21}$, a hydroxy group, a nitro group, CN, a halogen atom, or $COOR^{21}$.

$R^{21}$, $R^{22}$, and $R^{23}$ have the same meaning as described above.

A hydrogen atom of the group represented by $R^{21}$, $R^{22}$, or $R^{23}$ is optionally replaced by CN, a halogen atom, a hydroxy group, or a carboxy group.

When the group represented by $R^{21}$, $R^{22}$, or $R^{23}$ has an alkylene moiety, the alkylene moiety may be interrupted 1 or more and 5 or less times by -O-, -S-, -COO-, - OCO-, $-NR^{24}-$, $-NR^{24}CO-$, $-NR^{24}COO-$, $-OCONR^{24}-$, -SCO-, -COS-,

-OCS-, or -CSO-.

$R^{24}$ has the same meaning as described above.

When the group represented by $R^{21}$, $R^{22}$, or $R^{23}$ has an alkyl moiety, the alkyl moiety may be branched or cyclic, and $R^{22}$ and $R^{23}$ may together form a ring.

$R^{72}$, $R^{73}$, and three $R^{74}$ each independently represent $R^{61}$, $OR^{61}$, $SR^{61}$, $COR^{62}$, $CONR^{63}R^{64}$, $NR^{65}COR^{61}$, $OCOR^{61}$, $COOR^{62}$, $SCOR^{61}$, $OCSR^{61}$, $COSR^{62}$, $CSOR^{61}$, a hydroxy group, a nitro group, CN, or a halogen atom.

$R^{61}$, $R^{62}$, $R^{63}$, $R^{64}$, and $R^{65}$ each independently represent a hydrogen atom, an alkyl group having 1 or more and 20 or less carbon atoms, an aryl group having 6 or more and 30 or less carbon atoms, an arylalkyl group having 7 or more and 30 or less carbon atoms, or a heterocyclic group having 2 or more and 20 or less carbon atoms.

A hydrogen atom of the group represented by $R^{61}$, $R^{62}$, $R^{63}$, $R^{64}$, or $R^{65}$ is optionally replaced by $OR^{21}$, $COR^{21}$, $SR^{21}$, $NR^{22}R^{23}$, $CONR^{22}R^{23}$, $-NR^{22}-OR^{23}$, $-N(COR^{22})-OCOR^{23}$, $-C(=N-OR^{21})-R^{22}$, $-C(=N-OCOR^{21})-R^{22}$, CN, a halogen atom, or $COOR^{21}$.

$R^{72}$ and $R^{73}$; and two $R^{74}$ each may together form a ring.

**[0222]** * represents a bond to the first molecular structure of the oxime compound (1).

For the alkyl group having 1 or more and 20 or less carbon atoms, the aryl group having 6 or more and 30 or less carbon atoms, the aralkyl group having 7 or more and 30 or less carbon atoms, and the heterocyclic group having 2 or more and 20 or less carbon atoms represented by $R^{71}$, $R^{21}$, $R^{22}$, $R^{23}$, $R^{24}$, $R^{61}$, $R^{62}$, $R^{63}$, $R^{64}$ or $R^{65}$ in the formula (4), examples thereof include those listed for $R^{11}$, $R^{12}$, $R^{13}$, $R^{21}$, $R^{22}$, $R^{23}$, and $R^{24}$ in the formula (1).

For the formula (4), the phrase "$R^{22}$ and $R^{23}$ may together form a ring" means that $R^{22}$ and $R^{23}$, together with the nitrogen atom, the carbon atom, or the oxygen atom connected thereto, may form a ring.

Examples of the ring that may be formed by $R^{22}$ and $R^{23}$ together in the formula (4) include those listed for the ring that may be formed by $R^{12}$ and $R^{13}$, or $R^{22}$ and $R^{23}$ together in the formula (1).

Examples of the halogen atom represented by $R^{72}$, $R^{73}$ or $R^{74}$ in the formula (4) and the halogen atom that may replace a hydrogen atom of $R^{71}$, $R^{21}$, $R^{22}$, $R^{23}$, $R^{61}$, $R^{62}$, $R^{63}$, $R^{64}$, or $R^{65}$ include a fluorine atom, a chlorine atom, a bromine atom, and an iodine atom.

The method for producing the oxime compound (1) having the second molecular structure represented by the formula (4) is not particularly limited, and such an oxime compound can be produced by a method described in WO 2017/051680 A1 or WO 2020/004601 A1, for example.

Still another example of the second molecular structure linked to the first molecular structure represented by the formula (1) is a structure represented by the formula (5) below.

The bond represented by "*" in the formula (5) is directly bonded to the bond represented by "*" in the formula (1). In other words, when the second molecular structure is the structure represented by the formula (5), the pyrrole ring having "-*" in the formula (5) is directly bonded to the carbonyl group having "-*" in the formula (1).

[0179] [Formula 21]

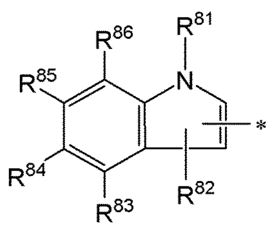

(5)

In the formula (5), $R^{81}$ represents a hydrogen atom, an alkyl group having 1 or more and 20 or less carbon atoms, an aryl group having 6 or more and 30 or less carbon atoms, an aralkyl group having 7 or more and 30 or less carbon atoms, or a heterocyclic group having 2 or more and 20 or less carbon atoms.

When the group represented by $R^{81}$ has an alkyl moiety, the alkyl moiety may be branched or may be cyclic.

A hydrogen atom of the group represented by $R^{81}$ is optionally replaced by $R^{21}$, $OR^{21}$, $COR^{21}$, $SR^{21}$, $NR^{22}R^{23}$, $CONR^{22}R^{23}$, $-NR^{22}-OR^{23}$, $-N(COR^{22})-OCOR^{23}$, $NR^{22}COR^{21}$, $OCOR^{21}$, $COOR^{21}$, $-C(=N-OR^{21})-R^{22}$, $-C(=N-OCOR^{21})-R^{22}$, $SCOR^{21}$, $OCSR^{21}$, $COSR^{21}$, $CSOR^{21}$, a hydroxy group, a nitro group, CN, a halogen atom, or $COOR^{21}$.

$R^{21}$, $R^{22}$, and $R^{23}$ each have the same meaning as described above.

A hydrogen atom of the group represented by $R^{21}$, $R^{22}$, or $R^{23}$ is optionally replaced by CN, a halogen atom, a hydroxy group, or a carboxy group.

When the group represented by $R^{21}$, $R^{22}$, or $R^{23}$ has an alkylene moiety, the alkylene moiety may be interrupted by 1 or more and 5 or less times by -O-, -S-, -COO-, -OCO-, $-NR^{24}-$, $-NR^{24}CO-$, $-NR^{24}COO-$, $-OCONR^{24}-$, -SCO-, -COS-, -OCS-, or -CSO-.

$R^{24}$ has the same meaning as described above.

When the group represented by $R^{21}$, $R^{22}$, or $R^{23}$ has an alkyl moiety, the alkyl moiety may be branched or cyclic, and $R^{22}$ and $R^{23}$ may together form a ring.

$R^{82}$, $R^{83}$, $R^{84}$, $R^{85}$, and $R^{86}$ each independently represent $R^{61}$, $OR^{61}$, $SR^{61}$, $COR^{62}$, $CONR^{63}R^{64}$, $NR^{65}COR^{61}$, $OCOR^{61}$, $COOR^{62}$, $SCOR^{61}$, $OCSR^{61}$, $COSR^{62}$, $CSOR^{61}$, a hydroxy group, a nitro group, CN, or a halogen atom.

$R^{61}$, $R^{62}$, $R^{63}$, $R^{64}$, and $R^{65}$ each independently represent a hydrogen atom, an alkyl group having 1 or more and 20 or less carbon atoms, an aryl group having 6 or more and 30 or less carbon atoms, an arylalkyl group having 7 or more and 30 or less carbon atoms, or a heterocyclic group having 2 or more and 20 or less carbon atoms.

A hydrogen atom of the group represented by $R^{61}$, $R^{62}$, $R^{63}$, $R^{64}$, or $R^{65}$ is optionally replaced by $OR^{21}$, $COR^{21}$, $SR^{21}$, $NR^{22}R^{23}$, $CONR^{22}R^{23}$, $-NR^{22}-OR^{23}$, $-N(COR^{22})-OCOR^{23}$, $-C(=N-OR^{21})-R^{22}$, $-C(=N-OCOR^{21})-R^{22}$, CN, a halogen atom, or $COOR^{21}$.

$R^{83}$ and $R^{84}$; $R^{84}$ and $R^{85}$; and $R^{85}$ and $R^{86}$ each may together form a ring.

**[0242]** * represents a bond to the first molecular structure of the oxime compound (1).

For the alkyl group having 1 or more and 20 or less carbon atoms, the aryl group having 6 or more and 30 or less carbon atoms, the aralkyl group having 7 or more and 30 or less carbon atoms, and the heterocyclic group having 2 or more and 20 or less carbon atoms represented by $R^{81}$, $R^{21}$, $R^{22}$, $R^{23}$, $R^{24}$, $R^{61}$, $R^{62}$, $R^{63}$, $R^{64}$ or $R^{65}$ in the formula (5), examples thereof include those listed for $R^{11}$, $R^{12}$, $R^{13}$, $R^{21}$, $R^{22}$, $R^{23}$, and $R^{24}$ in the formula (1).

For the formula (5), the phrase "$R^{22}$ and $R^{23}$ may together form a ring" means that $R^{22}$ and $R^{23}$, together with the nitrogen atom, the carbon atom, or the oxygen atom connected thereto, may form a ring.

Examples of the ring that may be formed by $R^{22}$ and $R^{23}$ together in the formula (5) include those listed for the ring that may be formed by $R^{12}$ and $R^{13}$, or $R^{22}$ and $R^{23}$ together in the formula (1).

Examples of the halogen atom represented by $R^{82}$, $R^{83}$, $R^{84}$, $R^{85}$, or $R^{86}$ in the formula (5) and the halogen atom that may replace a hydrogen atom of $R^{81}$, $R^{21}$, $R^{22}$, $R^{23}$, $R^{61}$, $R^{62}$, $R^{63}$, $R^{64}$, or $R^{65}$ include a fluorine atom, a chlorine atom, a bromine atom, and an iodine atom.

The method for producing the oxime compound (1) having the second molecular structure represented by the formula (5) is not particularly limited, and such an oxime compound can be produced by a method described in WO 2017/051680 A1 or WO 2020/004601 A1, for example.

Still another example of the second molecular structure linked to the first molecular structure represented by the formula (1) is a structure represented by the formula (6) below.

The bond represented by "*" in the formula (6) is directly bonded to the bond represented by "*" in the formula (1). In other words, when the second molecular structure is the structure represented by the formula (6), the benzene ring having "-*" in the formula (6) is directly bonded to the carbonyl group having "-*" in the formula (1).

[Formula 22]

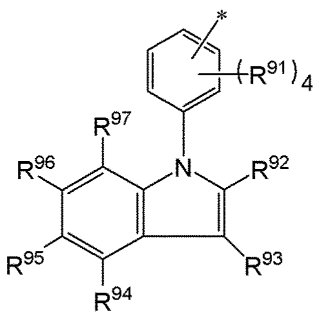

(6)

In the formula (6), a number 4 of $R^{91}$, and $R^{92}$, $R^{93}$, $R^{94}$, $R^{95}$, $R^{96}$, and $R^{97}$ each independently represent $R^{61}$, $OR^{61}$, $SR^{61}$, $COR^{62}$, $CONR^{63}R^{64}$, $NR^{65}COR^{61}$, $OCOR^{61}$, $COOR^{62}$, $SCOR^{61}$, $OCSR^{61}$, $COSR^{62}$, $CSOR^{61}$, a hydroxy group, a nitro group, CN, or a halogen atom.

$R^{61}$, $R^{62}$, $R^{63}$, $R^{64}$, and $R^{65}$ each independently represent a hydrogen atom, an alkyl group having 1 or more and 20 or less carbon atoms, an aryl group having 6 or more and 30 or less carbon atoms, an arylalkyl group having 7 or more and 30 or less carbon atoms, or a heterocyclic group having 2 or more and 20 or less carbon atoms.

A hydrogen atom of the group represented by $R^{61}$, $R^{62}$, $R^{63}$, $R^{64}$, or $R^{65}$ is optionally replaced by $OR^{21}$, $COR^{21}$, $SR^{21}$, $NR^{22}R^{23}$, $CONR^{22}R^{23}$, $-NR^{22}-OR^{23}$, $-N(COR^{22})-OCOR^{23}$, $-C(=N-OR^{21})-R^{22}$, $-C(=N-OCOR^{21})-R^{22}$, CN, a halogen atom, or $COOR^{21}$.

$R^{21}$, $R^{22}$, and $R^{23}$ each have the same meaning as described above.

$R^{92}$ and $R^{93}$; $R^{94}$ and $R^{95}$; $R^{95}$ and $R^{96}$; and $R^{96}$ and $R^{97}$ each may together form a ring.

**[0255]** * represents a bond to the first molecular structure of the oxime compound (1).

For the alkyl group having 1 or more and 20 or less carbon atoms, the aryl group having 6 or more and 30 or less

carbon atoms, the aralkyl group having 7 or more and 30 or less carbon atoms, and the heterocyclic group having 2 or more and 20 or less carbon atoms represented by $R^{21}$, $R^{22}$, $R^{23}$, $R^{61}$, $R^{62}$, $R^{63}$, $R^{64}$, or $R^{65}$ in the formula (6), examples thereof include those listed for $R^{11}$, $R^{12}$, $R^{13}$, $R^{21}$, $R^{22}$, and $R^{23}$ in the formula (1).

For the formula (6), the phrase "$R^{22}$ and $R^{23}$ may together form a ring" means that $R^{22}$ and $R^{23}$, together with the nitrogen atom, the carbon atom, or the oxygen atom connected thereto, may form a ring.

Examples of the ring that may be formed by $R^{22}$ and $R^{23}$ together in the formula (6) include those listed for the ring that may be formed by $R^{12}$ and $R^{13}$, or $R^{22}$ and $R^{23}$ together in the formula (1).

Examples of the halogen atom represented by $R^{91}$, $R^{92}$, $R^{93}$, $R^{94}$, $R^{95}$, $R^{96}$, or $R^{97}$ in the formula (6) and the halogen atom that may replace a hydrogen atom of $R^{21}$, $R^{22}$, $R^{23}$, $R^{61}$, $R^{62}$, $R^{63}$, $R^{64}$, or $R^{65}$ include a fluorine atom, a chlorine atom, a bromine atom, and an iodine atom.

The method for producing the oxime compound (1) having the second molecular structure represented by the formula (6) is not particularly limited, and such an oxime compound can be produced by a method described in WO 2017/051680 A1 or WO 2020/004601 A1, for example.

Other examples of the photopolymerization initiator include other photopolymerization initiators than the oxime compound (1). Examples of the other photopolymerization initiators include an oxime compound other than the oxime compound (1), an alkylphenone compound, a biimidazole compound, a triazine compound, and an acylphosphine compound.

Examples of an oxime compound other than the oxime compound (1) include an oxime compound having a partial structure represented by the following formula (d1). * represents a bond.

[0194] [Formula 23]

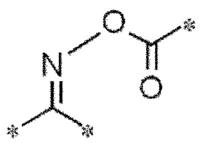

(d1)

Examples of the oxime compound having a partial structure represented by the formula (d1) include N-benzoyloxy-1-(4-phenylsulfanylphenyl)butan-1-one-2-imine, N-benzoyloxy-1-(4-phenylsulfanylphenyl)octan-1-one-2-imine, N-benzoyloxy-1-(4-phenylsulfanylphenyl)-3-cyclopentylpropan-1-one-2-imine, N-acetoxy-1-[9-ethyl-6-(2-methylbenzoyl)-9H-carbazole-3-yl]ethane-1-imine, N-acetoxy-1-[9-ethyl-6-{2-methyl-4-(3,3-dimethyl-2,4-dioxacyclopentanylmethyloxy)benzoyl}-9H-carbazole-3-yl]ethane-1-imine, N-acetoxy-1-[9-ethyl-6-(2-methylbenzoyl)-9H-carbazole-3-yl]-3-cyclopentylpropane-1-imine, and N-benzoyloxy-1-[9-ethyl-6-(2-methylbenzoyl)-9H-carbazole-3-yl]-3-cyclopentylpropan-1-one-2-imine, and compounds disclosed in JP 2011-132215 A, WO 2008/78678 A1, WO 2008/78686 A1, and WO 2012/132558 A1. Commercially available products may be used, including Irgacure (R) OXE01, OXE02, and OXE03 (all manufactured by BASF), and N-1919, NCI-930, and NCI-831 (all manufactured by ADEKA CORPORATION).

Among others, the oxime compound having a partial structure represented by the formula (d1) is preferably at least one selected from the group consisting of N-benzoyloxy-1-(4-phenylsulfanylphenyl)butan-1-one-2-imine, N-benzoyloxy-1-(4-phenylsulfanylphenyl)octan-1-one-2-imine, and N-benzoyloxy-1-(4-phenylsulfanylphenyl)-3-cyclopentylpropan-1-one-2-imine, and is more preferably N-benzoyloxy-1-(4-phenylsulfanylphenyl)octan-1-one-2-imine.

The alkylphenone compound is a compound having a partial structure represented by the following formula (d2) or a partial structure represented by the following formula (d3). In these partial structures, the benzene ring may have a substituent.

[Formula 24]

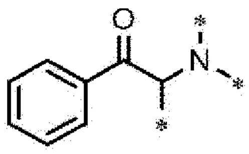

(d2)

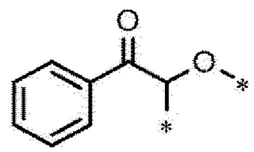

(d3)

Examples of the compound having a structure represented by the formula (d2) include 2-methyl-2-morpholino-1-(4-methylsulfanylphenyl)propan-1-one, 2-dimethylamino-1-(4-morpholinophenyl)-2-benzylbutan-1-one, and 2-(dimethylamino)-2-[(4-methylphenyl)methyl]-1-[4-(4-morpholinyl)phenyl]butan-1-one. Commercially available products may be used, including OMNIRAD (R) 369, 907, and 379 (all manufactured by IGM Resins B.V.).

Examples of the compound having a structure represented by the formula (d3) include 2-hydroxy-2-methyl-1-phenylpropan-1-one, 2-hydroxy-2-methyl-1-[4-(2-hydroxyethoxy)phenyl]propan-1-one, 1-hydroxycyclohexylphenyl ketone, an oligomer of 2-hydroxy-2-methyl-1-(4-isopropenylphenyl)propan-1-one, α,α-diethoxyacetophenone, and benzyl dimethyl ketal.

In view of sensitivity, the compound having a structure represented by the formula (d2) is preferable as the alkylphenone compound.

Examples of the biimidazole compound include a compound represented by the formula (d5):

[Formula 25]

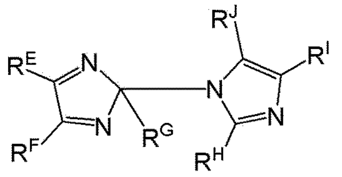

(d5)

[in the formula (d5), $R^E$ to $R^J$ represent an aryl group having 6 or more and 10 or less carbon atoms which may have a substituent.]

Examples of the aryl group having 6 or more and 10 or less carbon atoms include a phenyl group, a toluyl group, a xylyl group, an ethylphenyl group, and a naphthyl group, and a phenyl group is preferable.

Examples of the substituent include a halogen atom and an alkoxy group having 1 or more and 4 or less carbon atoms. Examples of the halogen atom include a fluorine atom, a chlorine atom, a bromine atom, and an iodine atom, and a chlorine atom is preferable. Examples of the alkoxy group having 1 or more and 4 or less carbon atoms include a methoxy group, an ethoxy group, a propoxy group, and a butoxy group, and a methoxy group is preferable.

Examples of the biimidazole compound include 2,2'-bis(2-chlorophenyl)-4,4',5,5'-tetraphenylbiimidazole, 2,2'-bis(2,3-dichlorophenyl)-4,4',5,5'-tetraphenylbiimidazole (for example, see JP H06-75372 A and JP H06-75373 A), 2,2'-bis(2-chlorophenyl)-4,4',5,5'-tetra(alkoxyphenyl)biimidazole, 2,2'-bis(2-chlorophenyl)-4,4',5,5'-tetra(dialkoxyphenyl)biimidazole, 2,2'-bis(2-chlorophenyl)-4,4',5,5'-tetra(trialkoxyphenyl)biimidazole (for example, see JP S48-38403 A and JP S62-174204 A), and a biimidazole compound in which phenyl groups at the 4,4',5,5' positions are each substituted with a carboalkoxy group (for example, see JP H7-10913 A). Among others, the compounds represented by the following formulas and a mixture thereof are preferable.

[Formula 26]

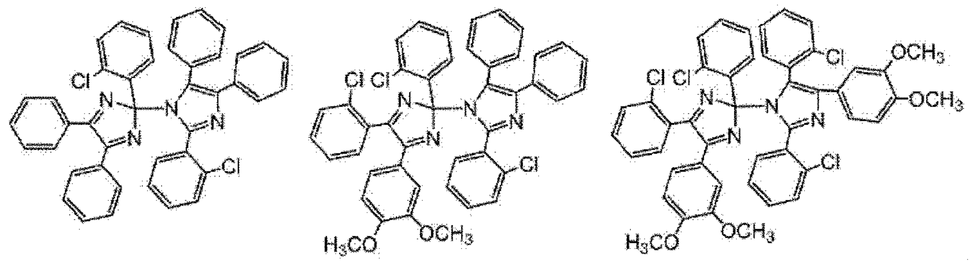

Examples of the triazine compound include 2,4-bis(trichloromethyl)-6-(4-methoxyphenyl)-1,3,5-triazine, 2,4-bis(trichloromethyl)-6-(4-methoxynaphthyl)-1,3,5-triazine, 2,4-bis(trichloromethyl)-6-piperonyl-1,3,5-triazine, 2,4-bis(trichloromethyl)-6-(4-methoxystyryl)-1,3,5-triazine, 2,4-bis(trichloromethyl)-6-[2-(5-methylfuran-2-yl)ethenyl]-1,3,5-triazine, 2,4-bis(trichloromethyl)-6-[2-(furan-2-yl)ethenyl]-1,3,5-triazine, 2,4-bis(trichloromethyl)-6-[2-(4-diethylamino-2-methylphenyl)ethenyl]-1,3,5-triazine, and 2,4-bis(trichloromethyl)-6-[2-(3,4-dimethoxyphenyl)ethenyl]-1,3,5-triazine. Among these, 2,4-bis(trichloromethyl)-6-piperonyl-1,3,5-triazine is preferable.

Examples of the acylphosphine compound include bis(2,4,6-trimethylbenzoyl)phenylphosphine oxide, and (2,4,6-trimethylbenzoyl)diphenylphosphine oxide. Commercially available products may be used, including OMNIRAD (R) 819 (manufactured by IGM Resins B.V.).

Other examples of the other photopolymerization initiators than the oxime compound (1) include a benzoin compound, such as benzoin, benzoin methyl ether, benzoin ethyl ether, benzoin isopropyl ether, and benzoin isobutyl ether; a benzophenone compound, such as benzophenone, methyl o-benzoyl benzoate, 4-phenylbenzophenone, 4-benzoyl-4'-methyldiphenyl sulfide, 3,3',4,4'-tetra(tert-butylperoxycarbonyl)benzophenone, 2,4,6-trimethylbenzophenone, and 4,4'-bis(diethylamino)benzophenone; a quinone compound, such as 9,10-phenanthrenequinone, 2-ethylanthraquinone, and camphorquinone; 10-butyl-2-chloroacridone, benzyl, methyl phenylglyoxylate, and a titanocene compound.

When the composition contains the polymerization initiator (D), the content of the polymerization initiator (D) in the composition is preferably 0.1 parts by mass or more, and preferably 300 parts by mass or less, more preferably 200 parts by mass or less, based on 100 parts by mass of the polymerizable compound (C). The content of the polymerization initiator (D) in the composition is preferably 0.1 parts by mass or more, more preferably 0.5 parts by mass or more, and preferably 30 parts by mass or less, more preferably 20 parts by mass or less, based on 100 parts by mass of the total amount of the vinyl copolymer (B) and the polymerizable compound (C). When the content of the polymerization initiator (D) is within the above-described range, there is a tendency that the composition has higher sensitivity and the exposure time is shortened, so that the productivity of the film tends to be improved.

[6] polymerization initiation aid (D1)

The composition can further contain a polymerization initiation aid (D1) together with the polymerization initiator (D). The polymerization initiation aid (D1) is a compound that is used to accelerate the polymerization of the polymerizable compound (C) initiated by the polymerization initiator (D), or a sensitizer. Examples of the polymerization initiation aid (D1) include a photopolymerization initiation aid, such as an amine compound, an alkoxy anthracene compound, a thioxanthone compound, and a carboxylic acid compounds, and a thermal polymerization initiation aid. The composition may include two or more kinds of the polymerization initiation aids (D1).

Examples of the amine compound include triethanolamine, methyldiethanolamine, triisopropanolamine, methyl 4-dimethylaminobenzoate, ethyl 4-dimethylaminobenzoate, isoamyl 4-dimethylaminobenzoate, 2-dimethylaminoethyl benzoate, 2-ethylhexyl 4-dimethylaminobenzoate, N,N-dimethylparatoluidine, 4,4'-bis(dimethylamino)benzophenone (common name: Michler's ketone), 4,4'-bis(diethylamino)benzophenone, and 4,4'-bis(ethylmethylamino)benzophenone.

Examples of the alkoxy anthracene compound include 9,10-dimethoxyanthracene, 2-ethyl-9,10-dimethoxyanthracene, 9,10-diethoxyanthracene, 2-ethyl-9,10-diethoxyanthracene, 9,10-dibutoxyanthracene, and 2-ethyl-9,10-dibutoxyanthracene.

Examples of the thioxanthone compound include 2-isopropylthioxanthone, 4-isopropylthioxanthone, 2,4-diethylthioxanthone, 2,4-dichlorothioxanthone, and 1-chloro-4-propoxythioxanthone.

Examples of the carboxylic acid compound include phenylsulfanylacetic acid, methylphenylsulfanylacetic acid, ethylphenylsulfanylacetic acid, methylethylphenylsulfanylacetic acid, dimethylphenylsulfanylacetic acid, methoxyphenysulfanylacetic acid, dimethoxyphenylsulfanylacetic acid, chlorophenylsulfanylacetic acid, dichlorophenylsulfanylacetic acid, N-phenylglycine, phenoxyacetic acid, naphthylthioacetic acid, N-naphthylglycine, and naphthoxyacetic acid.

When the composition contains the polymerization initiation aid (D1), the content of the polymerization initiation aid (D1) in the composition is preferably 0.1 parts by mass or more, and preferably 300 parts by mass or less, more preferably 200 parts by mass or less, based on 100 parts by mass of the polymerizable compound (C). The content of the polymerization initiation aid (D1) in the composition is preferably 0.1 parts by mass or more, more preferably 1 part by mass or more, and preferably 30 parts by mass or less, more preferably 20 parts by mass or less, based on 100 parts by mass of the total amount of the vinyl copolymer (B) and the polymerizable compound (C). When the content of the polymerization initiation aid (D1) is within the above-described range, the composition can have further high sensitivity.

[7] Solvent (E)

The composition can contain one or two or more solvents (E). The solvent (E) preferably dissolves the vinyl copolymer (B), the polymerizable compound (C), and the polymerization initiator (D). Examples of the solvent (E) include an ester solvent (a solvent having -COO- and having no -O- in the molecule), an ether solvent (a solvent having -O- and having no -COO- in the molecule), an ether ester solvent (a solvent having -COO- and -O- in the molecule), a ketone solvent (a solvent having -CO- and having no -COO- in the molecule), an alcohol solvent (a solvent having OH and having neither -O-, -CO-, nor COO- in the molecule), an aromatic hydrocarbon solvent, an amide solvent, and dimethyl sulfoxide.

Examples of the ester solvent include methyl lactate, ethyl lactate, n-butyl lactate, methyl 2-hydroxyisobutanoate, ethyl acetate, n-butyl acetate, isobutyl acetate, n-pentyl formate, isopentyl acetate, n-butyl propionate, isopropyl butyrate, ethyl butyrate, n-butyl butyrate, methyl pyruvate, ethyl pyruvate, propyl pyruvate, methyl acetoacetate, ethyl acetoacetate, cyclohexanol acetate, and $\gamma$-butyrolactone.

Examples of the ether solvent include ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monobutyl ether, propylene glycol monomethyl ether, propylene glycol monoethyl ether, propylene glycol monopropyl ether, propylene glycol monobutyl ether, 3-methoxy-1-butanol, 3-methoxy-3-methylbutanol, tetrahydrofuran, tetrahydropyran, 1,4-dioxane, diethylene glycol dimethyl ether, diethylene glycol diethyl ether, diethylene glycol methyl ethyl ether, diethylene glycol dipropyl ether, diethylene glycol dibutyl ether, anisole, phenetol, and methyl anisole.

Examples of the ether ester solvent include methyl methoxyacetate, ethyl methoxyacetate, butyl methoxyacetate, methyl ethoxyacetate, ethyl ethoxyacetate, methyl 3-methoxypropionate, ethyl 3-methoxypropionate, methyl 3-ethoxypropionate, ethyl 3-ethoxypropionate, methyl 2-methoxypropionate, ethyl 2-methoxypropionate, propyl 2-methoxypropionate, methyl 2-ethoxypropionate, ethyl 2-ethoxypropionate, methyl 2-methoxy-2-methylpropionate, ethyl 2-ethoxy-2-methylpropionate, 3-methoxybutylacetate, 3-methyl-3-methoxybutyl acetate, propylene glycol monomethyl ether acetate, propylene glycol monoethyl ether acetate, propylene glycol monopropyl ether acetate, ethylene glycol monomethyl ether acetate, ethylene glycol monoethyl ether acetate, diethylene glycol monoethyl ether acetate, and diethylene glycol monobutyl ether acetate.

Examples of the ketone solvent include 4-hydroxy-4-methyl-2-pentanone, acetone, 2-butanone, 2-heptanone, 3-heptanone, 4-heptanone, 4-methyl-2-pentanone, cyclopentanone, cyclohexanone, and isophorone.

Examples of the alcohol solvent include methanol, ethanol, propanol, butanol, hexanol, cyclohexanol, ethylene glycol, propylene glycol, and glycerin. Examples of the aromatic hydrocarbon solvent include benzene, toluene, xylene, and mesitylene. Examples of the amide solvent include N,N-dimethylformamide, N,N-dimethylacetamide, and N-methylpyrrolidone.

The solvent (E) preferably contains one or two or more selected from the group consisting of propylene glycol monomethyl ether acetate, ethyl lactate, propylene glycol monomethyl ether, ethyl 3-ethoxypropionate, ethylene glycol monomethyl ether, diethylene glycol monomethyl ether, diethylene glycol monoethyl ether, 4-hydroxy-4-methyl-2-pentanone, and an aromatic hydrocarbon solvent.

The solvent (E) is the component other than the solids content, and for example, the solvents contained in a dispersion of the quantum dot (A), a solution of the vinyl copolymer (B), and the like are also included in the solvent (E).

The content ratio of the solvent (E) in the composition is the proportion of the total mass of all the solvents contained in the composition based on the total amount of the composition, and is for example, 40% by mass or more, preferably 55% by mass or more, and for example, 95% by mass or less, preferably 90% by mass or less, based on the total amount of the composition. In other words, the solids content of the composition is, for example, 5% by mass or more, preferably 10% by mass or more, and for example, 60% by mass or less, preferably 45% by mass or less. When the content ratio of the solvent (E) is within the above-described range, there is tendency that the flatness of the composition layer upon application is more favorable and a film having an appropriate thickness is easily formed.

[8] Light scattering agent (F)

The composition can further contain a light scattering agent (F). The film formed from the composition may exhibit light scattering properties. The composition may contain two or more kinds of the light scattering agents (F). From the viewpoint of improving the light-emitting characteristics of the film, the composition preferably further contains the light scattering agent (F).

Examples of the light scattering agent (F) include inorganic particles such as particles of metal or metal oxide, and glass particles. Examples of the metal oxide include $TiO_2$, $SiO_2$, $BaTiO_3$, and ZnO, and particles of $TiO_2$, which efficiently scatter light, are preferable. The particle size of the light scattering agent (F) is, for example, about 0.03 μm or more, preferably 0.05 μm or more, and for example, about 20 μm or less, preferably 1 μm or less, more preferably 0.5 μm or less.

As the light scattering agent (F), one obtained by dispersing a light scattering agent in a part or all of the solvent (E) in advance using a dispersant may be used. A commercially available product can be used as the dispersant. Examples of the commercially available product include:

DISPERBYK-101, 102, 103, 106, 107, 108, 109, 110, 111, 116, 118, 130, 140, 154, 161, 162, 163, 164, 165, 166, 170, 171, 174, 180, 181, 182, 183, 184, 185, 190, 192, 2000, 2001, 2020, 2025, 2050, 2070, 2095, 2150, and 2155; ANTI-TERRA-U, U100, 203, 204, and 250; BYK-P104, P104S, P105, 220S, and 6919; BYK-LPN6919 and 21116; LACTIMON, LACTIMON-WS; and Bykumen manufactured by BYK-Chemie Japan;

SOLSPERSE-3000, 9000, 13000, 13240, 13650, 13940, 16000, 17000, 18000, 20000, 21000, 24000, 26000, 27000, 28000, 31845, 32000, 32500, 32550, 33500, 32600, 34750, 35100, 36600, 38500, 41000, 41090, 53095, 55000, 76500 manufactured by The Lubrizol Corporation;

EFKA-46, 47, 48, 452, 4008, 4009, 4010, 4015, 4020, 4047, 4050, 4055, 4060, 4080, 4400, 4401, 4402, 4403, 4406, 4408, 4300, 4310, 4320, 4330, 4340, 450, 451, 453, 4540, 4550, 4560, 4800, 5010, 5065, 5066, 5070, 7500, 7554, 1101, 120, 150, 1501, 1502, and 1503 manufactured by BASF; and

AJISPER PA111, PB711, PB821, PB822, and PB824 manufactured by Ajinomoto Fine-Techno Co., Inc.

When the composition contains the light scattering agent (F), the content ratio of the light scattering agent (F) in the composition is, for example, 0.001% by mass or more and 50% by mass or less, based on the total amount of the solids content of the composition, and from the viewpoint of improving the light scattering properties and light-emitting characteristics of the film, it is preferably 1% by mass or more, more preferably 2% by mass or more, even more

preferably 3% by mass or more, and preferably 30% by mass or less, more preferably 20% by mass or less, even more preferably 15% by mass or less, still more preferably 10% by mass or less.

[9] Antioxidant (H)

The composition can further contain an antioxidant (H). The antioxidant (H) is not particularly limited, as long as it is an antioxidant for general industrial use, and a phenol-based antioxidant, a phosphorus antioxidant, a phosphorus/phenol composite antioxidant, and a sulfur antioxidant can be used, for example. The composition may contain two or more kinds of the antioxidants (H).
The phosphorus/phenol composite antioxidant is, for example, a compound having one or more phosphorous atoms and one or more phenol structures per molecule. Among these, from the viewpoint of the developability of the composition and the light-emitting characteristics of the film, the antioxidant (H) preferably contains the phosphorus/phenol composite antioxidant.
Examples of the phenol-based antioxidant include Irganox (R) 1010 (Irganox 1010: pentaerythritol tetrakis [3-(3,5-di-tert-butyl-4-hydroxyphenyl)propionate], manufactured by BASF Japan Ltd.), Irganox 1076 (Irganox 1076: Octadecyl-3-(3,5-di-tert-butyl-4-hydroxyphenyl)propionate, manufactured by BASF Japan Ltd.), Irganox 1330 (Irganox 1330: 3,3',3",5,5',5"-hexa-tert-butyl-a,a',a"-(mesitylene-2,4,6-triyl)tri-p-cresol, BASF Japan Ltd.), Irganox 3114 (Irganox 3114: 1,3,5-tris(3,5-di-tert-butyl-4-hydroxybenzyl)-1,3,5-triazine-2,4,6(1H,3H,5H)-trione, BASF Japan Ltd.), Irganox 3790 (Irganox 3790: 1,3,5-tris((4-tert-butyl-3-hydroxy-2,6-xylyl)methyl)-1,3,5-triazine-2,4,6(1H,3H,5H)-trione, BASF Japan Ltd.), Irganox 1035 (Irganox 1035: thiodiethylenebis[3-(3,5-di-tert-butyl-4 hydroxyphenyl)propionate], manufactured by BASF Japan Ltd.), Irganox 1135 (Irganox 1135: 3,5-bis(1,1-dimethylethyl)-4-hydroxy-C7-C9 side-chain alkyl ester of benzene propanoic acid, manufactured by BASF Japan Ltd.), Irganox 1520 L (Irganox 1520 L: 4,6-bis(octylthiomethyl)-o-cresol, manufactured by BASF Japan Ltd.), Irganox 3125 (Irganox 3125, manufactured by BASF Japan Ltd.), Irganox 565 (Irganox 565: 2,4-bis(n-octylthio)-6-(4-hydroxy-3',5'-di-tert-butylanilino)-1,3,5-triazine, manufactured by BASF Japan Ltd.), ADK STAB (R) AO-80 (ADK STAB AO-80: 3,9-bis(2-(3-(3-tert-butyl-4-hydroxy-5-methylphenyl)propionyloxy)-1,1-dimethylethyl)-2,4,8,10-tetraoxaspiro(5,5)undecane, manufactured by ADEKA Corporation), SUMILIZER (R) BHT, SUMILIZER GA-80, SUMILIZER GS (manufactured by Sumitomo Chemical Co., Ltd.), Cyanox (R) 1790 (Cyanox 1790, manufactured by Cytec Industries Inc.), and vitamin E (manufactured by Eisai Co., Ltd.).
Examples of the phosphorus antioxidant include Irgafos (R) 168 (Irgafos 168: tris(2,4-di-tert-butylphenyl) phosphite, manufactured by BASF Japan Ltd.), Irgafos (R) 12 (Irgafos 12: tris[2-[[2,4,8,10-tetra-tert-butyl dibenzo[d,f][1,3,2]dioxaphosphin-6-yl]oxy]ethyl]amine, manufactured by BASF Japan Ltd.), Irgafos (R) 38 (Irgafos 38: bis(2,4-bis(1,1-dimethylethyl)-6-methylphenyl) ethyl phosphite, manufactured by BASF Japan Ltd.), ADK STAB (R) 329K, PEP36, and PEP-8 (all manufactured by ADEKA Corporation), Sandstab P-EPQ (manufactured by CLARIANT), Weston (R) 618 and 619G (manufactured by GE), and Ultranox 626 (manufactured by GE).
Examples of the phosphorus/phenol composite antioxidant include SUMILIZER (R) GP (6-[3-(3-tert-butyl-4-hydroxy-5-methylphenyl)propoxy]-2,4,8,10-tetra-tert-butyldibenzo[d,f][1.3.2]dioxaphosphepine) (manufactured by Sumitomo Chemical Co., Ltd.).
Examples of the sulfur-based antioxidant include dialkyl thiodipropionate compounds such as dilauryl thiodipropionate, dimyristyl thiodipropionate, and distearate thiodipropionate; and β-alkylmercaptopropionic acid ester compounds of polyols such as tetrakis[methylene(3-dodecylthio)propionate]methane.
When the composition contains the antioxidant (H), the content of the antioxidant (H) in the composition is, for example, 1 part by mass or more and 50 parts by mass or less, based on 100 parts by mass of the vinyl copolymer (B), and from the viewpoint of the light-emitting characteristics and heat resistance of the film, it is preferably 5 parts by mass or more, more preferably 7 parts by mass or more, and preferably 40 parts by mass or less, more preferably 30 parts by mass or less.

[10] Leveling agent (I)

The composition may further contain a leveling agent (I). Examples of the leveling agent (I) include a silicone surfactant, a fluorosurfactant, and a silicone surfactant having a fluorine atom. These may have a polymerizable group in a side chain thereof. The leveling agent (I) is preferably a fluorosurfactant, from the viewpoint of the developability of the composition and the light-emitting characteristics of the film. The composition may contain two or more kinds of the leveling agents (I).
Examples of the silicone surfactant include a surfactant having a siloxane bond in its molecule. Specific examples include TORAY silicone DC3PA, SH7PA, DC11PA, SH21PA, SH28PA, SH29PA, SH30PA, and SH8400 (product names: manufactured by Dow TORAY), KP321, KP322, KP323, KP324, KP326, KP340, and KP341 (manufactured by Shin-Etsu Chemical Co., Ltd.), TSF400, TSF401, TSF410, TSF4300, TSF4440, TSF4445, TSF4446, TSF4452, and TSF4460 (manufactured by Momentive Performance Materials Japan).

Examples of the fluorosurfactant include a surfactant having a fluorocarbon chain in its molecule. Specific examples include Fluorad (R) FC 430 and FC 431 (manufactured by Sumitomo 3M Limited), MEGAFACE (R) F142D, F171, F172, F173, F177, F183, F554, F575, R30, and RS-718-K (manufactured by DIC Corporation), F-top (R) EF301, EF303, EF351, and EF352 (manufactured by Mitsubishi Materials Electronic Chemicals Co., Ltd.), Surflon (R) S381, S382, SC101, and SC105 (manufactured by AGC Inc.), and E5844 (manufactured by Daikin Finechemicals Co., Ltd.)
Examples of the silicone surfactant having a fluorine atom include a surfactant having a siloxane bond and a fluorocarbon chain in its molecule. Specific examples include MEGAFACE (R) R08, BL20, F475, F477, and F443 (manufactured by DIC Corporation).
When the composition contains the leveling agent (I), the content ratio of the leveling agent (I) in the composition is, for example, 0.001% by mass or more, preferably 0.005% by mass or more, more preferably 0.01% by mass or more, even more preferably 0.05% by mass or more, and for example, 1.0% by mass or less, preferably 0.75% by mass or less, more preferably 0.5% by mass or less, based on the total amount of the composition. When the content ratio of the leveling agent (I) is within the above-described range, the flatness of the film can be more favorable.

[11] Other components

The composition may further contain additives known in the art, such as a polymerization inhibitor, a filler, other polymer compounds, an adhesion accelerator, a light stabilizer, and a chain transfer agent, if necessary.

<Method for producing composition>

The composition can be produced according to a method including mixing specific components, and other components that are used as necessary. The method for producing the composition can further include preparing the vinyl copolymer (B).

<Film and production method thereof>

The film according to the present invention is a film formed from the composition according to the present invention. The film can be used as a wavelength conversion layer in a display device and the like. The film can be provided on a base material by, for example,

a method a including applying a composition to a base material followed by drying, or
a method b in which a film is produced by a method including applying a composition to a support followed by drying, and the film is then stripped from the support and pasted to a base material via an adhesive layer.

In one embodiment, the composition is a non-curable resin composition R1. The film formed from the resin composition R1 can be formed by, for example, applying the composition to a base material or a support followed by drying.
In another embodiment, the composition is a curable resin composition R2 further containing the polymerizable compound (D) and the polymerization initiator (E). The vinyl copolymer (B) contained in the curable resin composition R2 may be curable or non-curable. The film formed from the curable resin composition R2 is a cured film. The cured film can be obtained by applying the curable resin composition R2 to a base material or a support followed by drying, and curing by action of light and/or heat. One aspect of the curable resin composition R2 is a photocurable resin composition R3 containing a photopolymerizable compound and a photopolymerization initiator.
The film may be provided on the entire surface of a base material, or may be provided on a part of a base material in a pattern shape. Examples of the method for forming a film on a base material in a pattern shape include a photolithography method, an inkjet method, and a printing method. Examples of the printing method include a stencil printing method, a screen printing method, and printing and application with an applicator.
Examples of the base material include a plate of glass such as silica glass, borosilicate glass, alumina silicate glass, and soda-lime glass having a silica-coated surface; a plate of resin such as polycarbonate, polymethyl methacrylate, and polyethylene terephthalate; silicon; those obtained by forming a thin film of aluminum, silver, or silver/copper/palladium alloy on any of these base materials; and a member that is contained or may be contained in a display device. Examples of the member that is contained or may be contained in a display device include a primary light source (for example, a blue light source), a light guide plate, a diffusion film (diffusion layer), a light reflection member (such as a reflection film), a brightness enhancement member, a prism sheet, a barrier layer, and a protection layer (an overcoat layer).
The film in a pattern shape formed from the resin composition R1 can be, for example, formed on a base material as follows. First, the resin composition R1 is applied on a base material via a mask to form a composition layer in a pattern shape. Examples of the method for applying the resin composition include spin coating, slit coating, and slit and spin

coating.

Next, the composition layer is dried (by removing volatile components such as the solvent) to obtain a film. Examples of the drying method include heat drying, drying under reduced pressure, or a combination thereof. The temperature in the case of heat drying is preferably 30°C or more, more preferably 50°C or more, and preferably 250°C or less, more preferably 235°C or less. The heating time is preferably 10 seconds or more, more preferably 30 seconds or more, and preferably 180 minutes or less, more preferably 90 minutes or less. In the case of drying under reduced pressure, drying is preferably carried out under pressure of 50 Pa or more and 150 Pa or less. Drying of the composition layer may be carried out in a plurality of stages, for example, by carrying out a plurality of drying with different drying temperatures.

For example, in the case of a method using the photolithography method, the cured film in a pattern shape formed from the photocurable resin composition R3 can be formed on a base material as follows. First, the photocurable resin composition R3 is applied on a base material, and subjected to heat drying (prebaking) and/or drying under reduced pressure to remove volatile components such as the solvent, thereby obtaining a composition layer. Examples of the application method include the same methods as above.

The temperature in the case of heat drying is preferably 30°C or more, more preferably 50°C or more, and preferably 120°C or less, more preferably 110°C or less. The heating time is preferably 10 seconds or more, more preferably 30 seconds or more, and preferably 60 minutes or less, more preferably 30 minutes or less. In the case of drying under reduced pressure, drying is preferably carried out under pressure of 50 Pa or more and 150 Pa or less in a temperature range of 20°C or more and 25°C or less.

Next, the composition layer is exposed via a photomask for forming a desired pattern shape. A light source used for exposure is preferably a light source generating light having a wavelength of 250 nm or more and 450 nm or less. For example, light having a wavelength of about 436 nm, about 408 nm, or about 365 nm may be selectively extracted from the light having the above wavelength according to the absorption wavelength of the photopolymerization initiator with a band pass filter. Specific examples of the light source include a mercury lamp, a light emitting diode, a metal halide lamp, and a halogen lamp.

Since the entire exposure surface can be uniformly irradiated with parallel rays or accurate positioning of a photomask and a base material on which the composition layer is formed can be carried out, an exposure device such as a mask aligner or a stepper is preferably used. The exposed composition layer is cured by polymerization of the vinyl copolymer (B), the photopolymerizable compound, and the like contained in the composition layer.

When the composition layer after exposure is brought into contact with a developer and developed, the unexposed portion of the composition layer is dissolved in the developer and removed, so that a cured film in a pattern shape is obtained. Examples of the developer include an aqueous solution of an alkaline compound such as potassium hydroxide, sodium bicarbonate, sodium carbonate, or tetramethyl ammonium hydroxide, and an organic solvent. The concentration of the aqueous solution of an alkaline compound is preferably 0.01% by mass or more, more preferably 0.03% by mass or more, and preferably 10% by mass or less, more preferably 5% by mass or less. Examples of the organic solvent include the same solvents as the solvents (E) described above. The developer may contain a surfactant.

The development method may be any of a puddle method, a dipping method, a spray method, and the like. Further, the base material may be inclined at an arbitrary angle upon development.

The film in a pattern shape obtained by development is preferably further subjected to heating (post-baking). The heating temperature is preferably 150°C or more, more preferably 160°C or more, and preferably 250°C or less, more preferably 235°C or less. The heating time is preferably 1 minute or more, more preferably 10 minutes or more, and preferably 120 minutes or less, more preferably 60 minutes or less. When heating is carried out after development, polymerization of the unreacted vinyl copolymer (B), photopolymerizable compound, and the like contained in the film can be proceeded, so that a cured film having more excellent chemical resistance can be obtained. Also when development is not carried out, the exposed composition layer is preferably further subjected to heating (post-baking).

On the other hand, examples of the method for forming a cured film on the entire surface of a base material include a method in which a curable resin composition is applied to a base material and, if necessary, dried to form a composition layer, and the composition layer is heated and/or the entire surface of the composition layer is subjected to exposure.

The thickness of the film is, for example, 1 μm or more, preferably 1.5 μm or more, more preferably 2 μm or more, and for example, 20 μm or less, preferably 18 μm or less, more preferably 14 μm or less, even more preferably 12 μm or less. When a film having an excessively small thickness and serving as a wavelength conversion layer is irradiated with primary light, the proportion of the primary light that is not sufficiently absorbed or scattered by the film and transmits the film tends to be larger. The shape and dimension of the film in a pattern shape is not particularly limited. In the film in a pattern shape, for example, its shape in a plan view is a square shape.

The film according to one embodiment is a wavelength conversion layer that absorbs primary light from a primary light source and emits green, and is preferably a wavelength conversion layer that converts a wavelength of blue light as primary light to a wavelength of green light. Green light emitted by the wavelength conversion layer preferably exhibits a peak having the maximum value within a wavelength range of 500 nm or more and 560 nm or less, more preferably a peak

having the maximum value within a wavelength range of 520 nm or more and 545 nm or less, and even more preferably a peak having the maximum value within a wavelength range of 525 nm or more and 535 nm or less, in the light emission spectrum. The peak preferably has a full width at half maximum of 15 nm or more, and preferably 80 nm or less, more preferably 60 nm or less, even more preferably 50 nm or less, particularly preferably 45 nm or less.

The film according to another embodiment is a wavelength conversion layer that absorbs primary light from a primary light source and emits red, and is preferably a wavelength conversion layer that converts a wavelength of blue light as primary light to a wavelength of red light. Red light emitted by the wavelength conversion layer preferably exhibits a peak having the maximum value within a wavelength range of 610 nm or more and 750 nm or less, more preferably a peak having the maximum value within a wavelength range of 620 nm or more and 650 nm or less, and even more preferably a peak having the maximum value within a wavelength range of 625 nm or more and 645 nm or less. The peak preferably has a full width at half maximum of 15 nm or more, and preferably 80 nm or less, more preferably 60 nm or less, even more preferably 50 nm or less, particularly preferably 45 nm or less.

<Display device>

The display device according to the present invention at least includes a light source and the above-described film. Examples of the display device include a liquid crystal display device, an organic EL display device, and an inorganic EL display device, and specific examples thereof include display devices described in JP 2006-309219 A, JP 2006-310303 A, JP 2013-15812 A, JP 2009-251129 A, and JP 2014-2363 A.

The display device according to one embodiment includes a backlight that is a blue light source, and a plurality of patterns provided on the visible side of the backlight. The plurality of patterns may be a red pattern, a green pattern, and a white (transparent, neutral color) pattern, and at least one of the red pattern and the green pattern may be the film according to the present invention. A chromatic color pattern that is a red pattern or green pattern containing quantum dots has a function of converting the wavelength of incident light and emitting the converted light. Examples

Hereinafter, the present invention will be described further in detail by way of Examples. In Examples, "%" and "parts" mean "% by mass " and "parts by mass", respectively, unless otherwise noticed.

<Measurement and evaluation>

(1) Measurement of thickness of film

The measurement was carried out using a profilometer for measuring the film thickness ("DektakXT" manufactured by Bruker).

(2) Measurement of light emission spectrum of quantum dot (A)

The measurement was carried out using an absolute PL quantum yield spectrometer ("C9920-02", manufactured by HAMAMATSU PHOTONICS K.K., excitation light 450 nm, room temperature, in air atmosphere) and a dispersion of the quantum dot (A) diluted such that the absorbance at a wavelength of 450 nm was 0.4 as the measurement sample.

(3) Measurement of molecular weight and molecular weight distribution of vinyl copolymer (B)

The gel permeation chromatography (GPC) measurement was carried out using a high performance liquid chromatograph (model name: HLC-8320 manufactured by Tosoh Corporation) under the following conditions, the calibration curve was prepared using the following standard substance, and the weight-average molecular weight (Mw) and the number-average molecular weight (Mn) were measured. The molecular weight distribution (Mw/Mn) was calculated from these measurement values.

Measurement sample: one obtained by methylating the carboxy group of the vinyl copolymer (B) using a trimethylsilyl diazomethane hexane solution

(concentration: 0.6 mol/L)

Sample concentration: 10 mg/mL
Sample injection volume: 10 μL
Flow rate: 0.35 mL/min
Column: two TSKgel SuperMultipore HZ-H (ϕ4.6 mm × 150 mm)

(manufactured by Tosoh Corporation)

Column temperature: 40°C
Mobile phase: tetrahydrofuran (THF)
Detector: differential refractometer detector
Standard substance: polystyrene (manufactured by Tosoh Corporation, TSK Standard)

(4) Measurement of ethylenic unsaturated bond equivalent of vinyl copolymer (B)

The ethylenic unsaturated bond equivalent that is the weight-average molecular weight per mole of the ethylenic unsaturated bond was determined based on the following equation.

$$\text{Ethylenic unsaturated bond equivalent [g/mol]} = W\ [g]/M\ [mol]$$

In the equation, W represents the mass [g] of the vinyl copolymer (B), and M represents the number of moles [mol] of the ethylenic double bond contained in W [g] of the vinyl copolymer (B). M was determined by measuring the number of the ethylenic double bond contained in 1 g of the copolymer in accordance with the method for testing the iodine value described in JIS 0070:1992.

(5) Measurement of acid value of vinyl copolymer (B)

The measurement sample (vinyl copolymer) was dissolved in THF, a few drops of a phenolphthalein ethanol solution is added thereto as an indicator, and neutralization titration was carried out with a 0.1 mol/L potassium hydroxide/2-propanol solution. The acid value (Av) was calculated using the following equation.

$$Av = 56.11 \times Vs \times 0.1 \times f/w$$

Av: acid value [mgKOH/g]
Vs: amount of 0.1 mol/L potassium hydroxide/2-propanol solution used in titration [mL]
f: titer of 0.1 mol/L potassium hydroxide/propanol solution
w: mass of measurement sample [g] (in terms of the solids content)

(6) Content of tellurium compound in vinyl copolymer (B)

Concentrated nitric acid and ultrapure water were mixed with the weighed measurement sample (vinyl copolymer), and the mixture was subjected to ashing treatment (decomposition of the vinyl polymer) by being irradiated with microwave. The tellurium content in the resulting ashing-treated solution was measured by inductively coupled plasma mass spectrometry (ICP/MS), and the amount of the tellurium compound based on the vinyl copolymer [ppm by mass] was calculated in terms of metal.

(7) Measurement of solids content of solution of vinyl copolymer (B)

About 1 g of the solution of the vinyl copolymer (B) was weighed in an aluminum cup and dried at 180°C for 1 hour, and the mass was then measured. From the amount of mass reduced, the solids content of the solution of the vinyl copolymer (B) [% by mass] was determined.

(8) Evaluation of patterning characteristics of film

The composition was applied to a 5 cm-square glass substrate ("EAGLE XG" manufactured by Corning Incorporated) by spin coating method such that the layer after post-baking had a thickness of 6.0 μm, and then prebaked at 100°C for 3 minutes in a clean oven to obtain a composition layer. After cooling, the composition layer was irradiated with light in air atmosphere in an amount of light exposed of 200 mJ/$cm^2$ (on a basis of a wavelength of 365 nm) using an exposure equipment (TME-150RSK; manufactured by TOPCON TECHNOHOUSE CORPORATION) by setting the distance between the substrate on which the composition layer was formed and a photomask made of quartz glass to 150 μm. The photomask used was a photomask for forming a 1:1 line-and-space pattern of 20 μm. The composition layer irradiated with light was immersed in an aqueous solution containing nonionic surfactant 0.14% and potassium hydroxide 0.048% at 25°C for 20 seconds for development, washed with water, and then post-baked at 180°C for 30 minutes in an oven to obtain a pattern made of a cured film on which a line and space pattern (having 10 lines and 10 spaces) with a line width of 20 μm was formed.

The resulting pattern was observed using a microscope (1000 times magnification; VHX-2000; manufactured by KEYENCE CORPORATION), and patterning characteristics were evaluated according to the following evaluation criteria. The results are shown in Table 4.

A: The pattern is formed in a line shape in accordance with the mask
B: Other than A (some spaces are not suitably formed, some line patterns are not suitably formed or are broken, etc.)

(9) Evaluation of light-emitting characteristics of film

(9-1) Quantum yield QY

The composition was applied to a 5 cm-square glass substrate ("EAGLE XG" manufactured by Corning Incorporated) by spin coating method such that the layer after post-baking had a thickness of 6 μm, and then prebaked at 100°C for 3 minutes in a clean oven to obtain a composition layer. The substrate on which the composition layer was formed was irradiated with light in air atmosphere in an amount of light exposed of 200 mJ/$cm^2$ (on a basis of 365 nm) using an exposure equipment (TME-150RSK; manufactured by TOPCON TECHNOHOUSE CORPORATION), developed, and then post-baked at 180°C for 30 minutes to obtain a substrate having a cured film.

The quantum yield QY was measured using a PL quantum yield spectrometer (automatic control electric monochromatic light source type, C9920-02G; manufactured by Hamamatsu Photonics K.K.). The measurement section used was an integrating sphere unit, a substrate sample having a cured film cut into a 1 cm-square was placed in the integrating sphere, and the reflection light obtained by applying excitation light from right above the sample was measured to obtain emission efficiency. A xenon lamp was used as the light source, and light having a wavelength of 450 nm was used as the excitation light.

QY obtained in Comparative Example 1 was used as the reference, and ΔQY that was a relative value [%] when ΔQY of Comparative Example 1 was regarded as 100% was calculated according to the following equation. The results are shown in Table 4.

ΔQY [%] = (QY of target Example or Comparative Example/QY of Comparative Example 1) × 100

(9-2) External quantum efficiency EQE

A substrate having a cured film was obtained in the same manner as the above (9-1).

A light-scattering plate was placed on a backlight with a blue LED lamp having a wavelength of the emission peak of 450 nm as a point light source, and the resultant was used as a backlight member. The backlight member was placed with the light-scattering plate facing upward, and a spectral radiance meter ("SR-UL1R" manufactured by TOPCON TECHNOHOUSE CORPORATION) was arranged at a position 60 cm above the surface of the light-scattering plate.

A substrate having a cured film prepared from the composition was placed on the above scattering plate. In that state, the backlight was turned on, and for the light emitted from the cured film, the emission intensity $L_g$ [$W \cdot sr^{-1} m^{-2} \cdot nm^{-1}$] of the cured film was measured as the integrated radiant flux within a wavelength range of 480 nm or more and 780 nm or less. Next, a 5 cm-square glass substrate ("EAGLE XG" manufactured by Corning Incorporated) was placed on the scattering plate, the backlight was turned on, and the emission intensity $L_f$ [$W \cdot sr^{-1} m^{-2} \cdot nm^{-1}$] of the backlight was measured as the integrated radiant flux within a wavelength range of 380 nm or more and 480 nm or less. In the measurement of the emission intensity, the above-described spectral radiance meter ("SR-UL1R" manufactured by TOPCON TECHNOHOUSE CORPORATION) was used.

The external quantum efficiency EQE was calculated using the following equation.

EQE [%] = emission intensity of cured film/emission intensity of backlight = Lg/Lf

EQE obtained in Comparative Example 1 was used as the reference, and ΔEQE that was a relative value [%] when ΔEQE of Comparative Example 1 was regarded as 100% was calculated according to the following equation. The results are shown in Table 4.

ΔEQE [%] = (EQE of target Example or Comparative Example/EQE of Comparative Example 1) × 100

(10) Evaluation of appearance of film

A substrate having a cured film was obtained in the same manner as the above (9-1). The resulting cured film was

observed using a microscope (500 times magnification; VHX-2000; manufactured by KEYENCE CORPORATION), and the appearance was evaluated according to the following evaluation criteria. The results are shown in Table 4.

A: No abnormality was found
B: Presence of aggregate was found

<Preparation Example 1: preparation of dispersion of quantum dot (A1)>

A dispersion a of the quantum dot (A1) [green emitting InP/ZnSeS quantum dot] in toluene that contains oleic acid as an organic ligand (G1) was prepared. The light emission spectrum of the quantum dot was measured and found that the wavelength of the maximum peak in the green emission peak was 530 nm and the full width at half maximum in the green emission peak was 42 nm.

After toluene was removed from the toluene dispersion a by distillation under reduced pressure, 70 parts of cyclohexylacetate (E2) was added to 30 parts of the total amount of the quantum dot (A1) and the organic ligand (G1) to obtain a dispersion b of the quantum dot (A1). The compositional feature of the dispersion b of the quantum dot (A1) is as shown in Table 1.

[Table 1]

| | | Dispersion b |
|---|---|---|
| Quantum dot (A) | A1 | 21.3 |
| Organic ligand (G) | G1 | 8.7 |
| Solvent (E) | E2 | 70 |

The compositional ratio of the quantum dot (A1) to the organic ligand (G1) was calculated by measuring the remaining amount when the mixture after toluene was removed was heated to 550°C at a temperature rising rate of 5°C/min by TG-DTA measurement, and regarding the remaining amount as the weight of the organic ligand (G1).

<Synthetic Examples 1 to 7: synthesis of vinyl copolymers (B1) to (B7)>

In a glove box purged with nitrogen, the reaction was carried out using monomers ((b-1) to (b-3)) purged with nitrogen in advance, ethyl=2-methyl-2-n-butyltellanyl-propionate (BTEE), dibutylditelluride (DBDT), 2,2'-azobis(isobutyronitrile) (AIBN), and propylene glycol monomethyl ether acetate (PGMEA) such that the copolymer to be obtained had the compositional feature described in Table 2. After termination of the reaction, the reaction solution was diluted with THF, and the diluted solution was poured into heptane under stirring. The precipitated polymer was filtered by suction, dried, and then dissolved in PGMEA to obtain each of the solutions of the vinyl copolymers (B1) to (B7). The solids content of each of the solutions of the vinyl copolymers (B1) to (B7) was 40% by mass.

The weight-average molecular weight (Mw), molecular weight distribution (Mw/Mn), acid value, and content of the tellurium compound of each of the resulting vinyl copolymers (B1) to (B7) are shown in Table 2.

[Table 2]

| | | | | | Synthetic Example 1 | Synthetic Example 2 | Synthetic Example 3 | Synthetic Example 4 | Synthetic Example 5 | Synthetic Example 6 | Synthetic Example 7 |
|---|---|---|---|---|---|---|---|---|---|---|---|
| Vinyl co-poly mer | No. | | | | B1 | B2 | B3 | B4 | B5 | B6 | B7 |
| | A block | (b-1) | MAA | mol% | 18.7 | 19.6 | 18.3 | 18.7 | 10.3 | 25.3 | 18.7 |
| | | (b-3) | MMA | mol% | 19.8 | 19.1 | 22.3 | 19.9 | 21.1 | 18.9 | 19.9 |
| | | | BMA | mol% | 34.1 | 32.8 | 38.3 | 34.1 | 36.2 | 32.4 | 34.1 |
| | B block | (b-2) | MOES A | mol % | 11.3 | - | - | 11.3 | 6.1 | 15.2 | 11.3 |
| | | | MOEB DA | mol % | - | 11.8 | 5.5 | - | - | - | - |
| | | (b-3) | MMA | mol% | 16.0 | 16.7 | 15.6 | 16.0 | 26.4 | 8.1 | 16.0 |
| | Physical property | Mw | | | 7371 | 7366 | 7171 | 9865 | 7052 | 7411 | 14828 |
| | | Mw/Mn | | | 1.54 | 1.50 | 1.49 | 2.11 | 1.50 | 1.54 | 2.14 |
| | | Acid value (mgKOH/g) | | | 131 | 131 | 108 | 133 | 80 | 176 | 137 |
| | | Content of tellurium compound (ppm) | | | 99 | 57 | 94 | 23 | 23 | 33 | 376 |

<Synthetic Examples 8 to 12: synthesis of vinyl copolymers (B8) to (B12)>

In a glove box purged with nitrogen, the reaction was carried out using monomers ((b-1) to (b-3)) purged with nitrogen in advance, BTEE, DBDT, AIBN, and PGMEA such that the copolymer intermediate to be obtained had the compositional feature described in Table 3. After termination of the reaction, the reaction solution was diluted with THF, and the diluted solution was poured into heptane under stirring. The precipitated polymer was filtered by suction and dried to obtain a copolymer intermediate.

Next, the copolymer intermediate obtained above, the monomer (b-4) of the kind and mole ratio described in Table 3, triethylamine (the mole ratio based on 1 mole of the monomer (b-4): 0.20), and PGMEA were mixed in air atmosphere, and the reaction was carried out by stirring the mixture at 120°C for 7 hours to obtain each of the solutions of the vinyl copolymers (B8) to (B12). The solids content of each of the solutions of the vinyl copolymers (B8) to (B12) was 40% by mass.

The weight-average molecular weight (Mw), molecular weight distribution (Mw/Mn), ethylenic unsaturated bond equivalent, acid value, and content of the tellurium compound of each of the resulting vinyl copolymers (B8) to (B12) are shown in Table 3.

<Synthetic Example 13: synthesis of vinyl copolymer (B13)>

In a glove box purged with nitrogen, the reaction was carried out using monomers ((b-1) to (b-3)) purged with nitrogen in advance, BTEE, DBDT, AIBN, and PGMEA such that the copolymer intermediate to be obtained had the compositional feature described in Table 3. After the termination of the reaction, the reaction solution was diluted with THF, and the diluted solution was poured into heptane under stirring. The precipitated polymer was filtered by suction and dried to obtain a copolymer intermediate.

Next, the copolymer intermediate obtained above, the monomer (b-4) of the type and mole ratio described in Table 3, triethylamine (the mole ratio based on 1 mole of the monomer (b-4): 0.20), 2,2,6,6-tetramethylpiperidinyl-1-oxyl (0.1 parts by mass based on 100 parts by mass of the copolymer intermediate), and PGMEA were mixed in air atmosphere, and the reaction was carried out by stirring the mixture at 120°C for 7 hours to obtain the solution of the vinyl copolymer (B13). The solids content of the solution of the vinyl copolymer (B13) was 40% by mass.

[Table 3]

| | | | | | | Synthetic Example 8 | Synthetic Example 9 | Synthetic Example 10 | Synthetic Example 11 | Synthetic Example 12 | Synthetic Example 13 |
|---|---|---|---|---|---|---|---|---|---|---|---|
| Vinyl co-poly mer | No. | | | | | B8 | B9 | B10 | B11 | B12 | B13 |
| | Copolymer interme diate | block | (b-1) | MAA | mol% | 24.5 | 24.5 | 24.5 | 24.5 | 38.2 | 24.5 |
| | | | (b-3) | MMA | mol% | 17.4 | 17.4 | 17.4 | 17.4 | 11.4 | 17.4 |
| | | | | BMA | mol% | 29.9 | 29.9 | 29.9 | 29.9 | 19.7 | 29.9 |
| | | B block | (b-2) | MOESA | mol% | 11.6 | 11.6 | 11.6 | 11.6 | 12.7 | 16.6 |
| | | | (b-3) | MMA | mol% | 16.5 | 16.5 | 16.5 | 16.5 | 18.1 | 16.5 |
| | (b-4) | GMA | | mole ratio based on carboxy group | | 0.144 | | | | 0.336 | 0.144 |
| | | ECHMA | | mole ratio based on carboxy group | | | 0.144 | | | | |
| | | ECHAA | | mole ratio based on carboxy group | | | | | 0.144 | | |
| | | 4HBAGE | | mole ratio based on carboxy group | | | | 0.144 | | | |
| | Physical property | Mw | | | | 7169 | 7391 | 6825 | 7497 | 14295 | 7108 |
| | | Mw/Mn | | | | 1.54 | 1.51 | 1.53 | 1.54 | 2.18 | 1.55 |
| | | Ethylenic unsaturated bond equivalent (g/mol) | | | | 3585 | 3696 | 3413 | 3749 | 2383 | 3554 |
| | | Acid value (mgKOH/g) | | | | 133 | 128 | 130 | 128 | 135 | 133 |
| | | Content of tellurium compound (ppm) | | | | 88 | 98 | 97 | 78 | 87 | 92 |

The meanings of the abbreviations in Table 2 and Table 3 are as follows.

MAA: methacrylic acid

MMA: methyl methacrylate

BMA: butyl methacrylate

MOESA: 2-methacryloyloxyethyl succinic acid

MOEBDA: mono-2-(methacryloyloxy)ethyl phthalate

GMA: glycidyl methacrylate

ECHMA: 3,4-epoxycyclohexylmethyl methacrylate

ECHAA: 3,4-epoxycyclohexylmethyl acrylate

4HBAGE: 4-hydroxybutylacrylate glycidyl ether

<Examples 1 to 8, Comparative Examples 1 to 5>

Each composition was prepared by mixing respective components in Table 4 in an amount described in Table 4 with the dispersion b of the quantum dot (A1). In Table 4, the number of parts of components other than the solvent (E) represents a value in terms of the solids content. The compositional features of the compositions in Examples 1 to 8 and Comparative Examples 1 to 5 are the same compositional features except for using one described in Table 4 (any of the vinyl copolymers (B1) to (B10)) as the vinyl copolymer (B).

The evaluation results of the patterning characteristics, light-emitting characteristics, and appearance of each film formed from the compositions of Examples 1 to 8 and Comparative Examples 1 to 5 are shown in Table 4. Since patterning characteristics were poor in Comparative Examples 2 and 3, the evaluation of light-emitting characteristics was not carried out. With respect to patterning characteristics, the cured film remained on a portion that should be a space, in Comparative Example 2. In Comparative Example 3, the cured film on a portion that was supposed to be a line partially disappeared by development.

[Table 4]

| | | Example | | | | | | | | Comparative Example | | | | |
|---|---|---|---|---|---|---|---|---|---|---|---|---|---|---|
| | | 1 | 2 | 3 | 4 | 5 | 6 | 7 | 8 | 1 | 2 | 3 | 4 | 5 |
| Quantum dot (A) | A1 | 68 | 68 | 68 | 68 | 68 | 68 | 68 | 68 | 68 | 68 | 68 | 68 | 68 |
| Organic ligand (G) | G1 | 24 | 24 | 24 | 24 | 24 | 24 | 24 | 24 | 24 | 24 | 24 | 24 | 24 |
| Vinyl copolymer (B) | No. | B1 | B2 | B3 | B8 | B9 | B10 | B11 | B13 | B4 | B5 | B6 | B7 | B12 |
| | | 70 | 70 | 70 | 70 | 70 | 70 | 70 | 70 | 70 | 70 | 70 | 70 | 70 |
| Polymerizable compound (C) | C1 | 30 | 30 | 30 | 30 | 30 | 30 | 30 | 30 | 30 | 30 | 30 | 30 | 30 |
| Polymerization initiator (D) | D1 | 1 | 1 | 1 | 1 | 1 | 1 | 1 | 1 | 1 | 1 | 1 | 1 | 1 |
| Light scattering agent (F) | F1 | 15 | 15 | 15 | 15 | 15 | 15 | 15 | 15 | 15 | 15 | 15 | 15 | 15 |
| Antioxidant (H) | H1 | 6 | 6 | 6 | 6 | 6 | 6 | 6 | 6 | 6 | 6 | 6 | 6 | 6 |
| Leveling agent (I) | I1 | 0.2 | 0.2 | 0.2 | 0.2 | 0.2 | 0.2 | 0.2 | 0.2 | 0.2 | 0.2 | 0.2 | 0.2 | 0.2 |

(continued)

| | | Example | | | | | | | | Comparative Example | | | | |
|---|---|---|---|---|---|---|---|---|---|---|---|---|---|---|
| | | 1 | 2 | 3 | 4 | 5 | 6 | 7 | 8 | 1 | 2 | 3 | 4 | 5 |
| Solvent (E) | E1 | 168 | 168 | 168 | 168 | 168 | 168 | 168 | 168 | 168 | 168 | 168 | 168 | 168 |
| | E2 | 217 | 217 | 217 | 217 | 217 | 217 | 217 | 217 | 217 | 217 | 217 | 217 | 217 |
| Patterning characteristics | | A | A | A | A | A | A | A | A | A | B | B | A | A |
| ΔQY (%) | | 105 | 104 | 102 | 103 | 101 | 104 | 101 | 103 | 100 | - | - | 72 | 93 |
| ΔEQE (%) | | 105 | 103 | 101 | 101 | 101 | 102 | 101 | 102 | 100 | - | - | 71 | 91 |
| Appearance | | A | A | A | A | A | A | A | A | B | A | A | B | B |

The details of the abbreviations of the components shown in Table 4 are as follows.

Organic ligand (G1): oleic acid
Polymerizable compound (C1): carboxy group-containing polyfunctional (meth)acrylate (product name: "ARONIX M-510", manufactured by TOAGOSEI CO., LTD.)
Polymerization initiator (D1): "Irgacure (R) OXE-02" manufactured by BASF
Light scattering agent (F1): One obtained by mixing 10 parts of the vinyl copolymer (B) (in terms of the solids content) and 30 parts of PGMEA in total with 60 parts of titanium oxide particles and sufficiently dispersing the titanium oxide particles using a bead mill was used in the preparation of the composition. The number of parts of the light scattering agent (F1) described in Table 4 is the number of parts of titanium oxide particles.
Antioxidant (H1): product name: "SUMILIZER GP" manufactured by Sumitomo Chemical Co., Ltd.
Leveling agent (I1): polyether-modified silicone oil (product name: "TORAY silicone SH8400" manufactured by Dow TORAY)
Solvent (E1): propylene glycol monomethyl ether acetate (PGMEA)
Solvent (E2): cyclohexyl acetate

## Claims

**1.** A composition comprising: a quantum dot (A) and a vinyl copolymer (B),

wherein the vinyl copolymer (B) has:

a structural unit derived from (meth)acrylic acid,
a structural unit derived from (meth)acrylate having a carboxy group, and
a structural unit derived from (meth)acrylate having no carboxy group;

contains a tellurium compound;
has a molecular weight distribution of 2.0 or less; and
has an acid value of 100 mgKOH/g to 150 mgKOH/g.

**2.** The composition according to claim 1, wherein the vinyl copolymer (B) has structural units derived from monomers represented by a formula (I), a formula (II), and a formula (III):

[Formula 1]

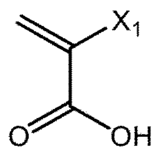

( I )

[in the formula (I), $X_1$ represents a hydrogen atom or a methyl group];

[Formula 2]

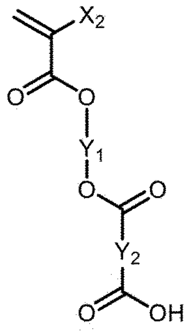

(I I)

[in the formula (II), $X_2$ represents a hydrogen atom or a methyl group, $Y_1$ represents a linear, branched, or cyclic hydrocarbon group having 1 to 6 carbon atoms, and $Y_2$ represents a linear, branched, or cyclic hydrocarbon group having 1 to 6 carbon atoms];

[Formula 3]

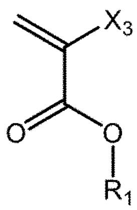

(I I I)

[in the formula (III), $X_3$ represents a hydrogen atom or a methyl group, and $R_1$ represents a linear, branched, or cyclic hydrocarbon group having 1 to 30 carbon atoms.].

**3.** The composition according to claim 1, wherein the vinyl copolymer (B) further has a structural unit having an ultraviolet curable functional group.

**4.** The composition according to claim 1, wherein the vinyl copolymer (B) has an ethylenic unsaturated bond equivalent being a weight-average molecular weight per mole of ethylenic unsaturated bond of more than 1000 and 8000 or less.

**5.** The composition according to claim 1, wherein a content of the tellurium compound in the vinyl copolymer (B) is more than 0 ppm and 350 ppm or less in terms of metal tellurium.

**6.** The composition according to claim 1, further comprising a polymerizable compound (C) and a polymerization initiator (D).

**7.** The composition according to claim 1, further comprising a solvent (E).

**8.** The composition according to claim 1, wherein the quantum dot (A) is at least one selected from the group consisting of a compound of a group 12 element and a group 16 element, a compound of a group 13 element and a group 15 element, a compound of a group 13 element and a group 16 element, and a compound of a group 14 element and a group 16 element.

**9.** The composition according to claim 1, wherein a content of the quantum dot (A) is 50 parts by mass to 350 parts by mass based on 100 parts by mass of the vinyl copolymer (B).

**10.** A film formed from the composition according to any one of claims 1 to 9.

**11.** A display device comprising the film according to claim 10.

**INTERNATIONAL SEARCH REPORT**

International application No. **PCT/JP2023/021091**

**A. CLASSIFICATION OF SUBJECT MATTER**

***C08L 33/00***(2006.01)i; ***C08F 2/44***(2006.01)i; ***C08F 220/02***(2006.01)i; ***C08F 293/00***(2006.01)i; ***C08K 3/10***(2018.01)i; ***C09K 11/02***(2006.01)i; ***C09K 11/70***(2006.01)i; ***C09K 11/88***(2006.01)i
FI: C08L33/00; C08F2/44 A; C08F2/44 C; C08F293/00; C08F220/02; C09K11/70; C09K11/02 Z; C09K11/88 ZNM; C08K3/10

According to International Patent Classification (IPC) or to both national classification and IPC

**B. FIELDS SEARCHED**

Minimum documentation searched (classification system followed by classification symbols)

C08L33/02-33/16; C08F220/02-220/50; C08F293/00; C08K3/00-3/40; C09K11/02; C09K11/70; C09K11/88

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2017-31398 A (JSR CORP) 09 February 2017 (2017-02-09) claims, paragraphs [0026], [0081], [0117]-[0122], [0127]-[0128], [0131], [0172]-[0208] | 1-11 |
| Y | JP 2021-161394 A (SUMITOMO CHEMICAL CO) 11 October 2021 (2021-10-11) claims, paragraphs [0104]-[0106] | 1-11 |
| A | JP 2016-65178 A (JSR CORP) 28 April 2016 (2016-04-28) | 1-11 |
| A | CN 111752098 A (CHANGZHOU TRONLY NEW ELECTRONIC MATERIALS CO., LTD.) 09 October 2020 (2020-10-09) | 1-11 |
| A | KR 10-2018-0106658 A (DONGWOO FINE-CHEM CO., LTD.) 01 October 2018 (2018-10-01) | 1-11 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **15 August 2023** | **29 August 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2023/021091**

| Patent document cited in search report | Publication date (day/month/year) | Patent family member(s) | Publication date (day/month/year) |
|---|---|---|---|
| JP 2017-31398 A | 09 February 2017 | WO 2017/018392 A1 | |
| | | TW 201710399 A | |
| | | KR 10-2018-0035732 A | |
| JP 2021-161394 A | 11 October 2021 | US 2023/0095579 A1 claims, paragraphs [0165]-[0170] | |
| | | WO 2021/200278 A1 | |
| | | EP 4130076 A1 | |
| | | TW 202138395 A | |
| | | CN 115362179 A | |
| | | KR 10-2022-0161280 A | |
| JP 2016-65178 A | 28 April 2016 | KR 10-2016-0036483 A | |
| | | TW 201612262 A | |
| CN 111752098 A | 09 October 2020 | (Family: none) | |
| KR 10-2018-0106658 A | 01 October 2018 | CN 108628100 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2016071362 A
- WO 200414848 A1
- WO 200414962 A1
- WO 2004072126 A1
- WO 2004096870 A1
- JP 2011132215 A
- JP 2000080068 A
- JP 2011178776 A
- WO 2017051680 A1
- WO 2020004601 A1
- WO 200878678 A1
- WO 200878686 A1
- WO 2012132558 A1
- JP H0675372 A
- JP H0675373 A
- JP S4838403 A
- JP S62174204 A
- JP H710913 A
- JP 2006309219 A
- JP 2006310303 A
- JP 2013015812 A
- JP 2009251129 A
- JP 2014002363 A